# EUROPÄISCHE PATENTSCHRIFT

(11) **EP 2 707 374 B1**
(45) Veröffentlichungstag und Bekanntmachung des Hinweises auf die Patenterteilung: **02.03.2016**
(21) Anmeldenummer: 12721517.6
(22) Anmeldetag: 14.05.2012
(51) Int. Cl.: C07F 9/58, C07F 9/6506, C07F 9/6512, C07F 9/6518, C07F 9/653, C07F 9/6539, H01L 51/50, H01L 51/00

(54) **KUPFER(I)KOMPLEXE, INSBESONDERE FÜR OPTOELEKTRONISCHE BAUELEMENTE**
COPPER(I)COMPLEXES, IN PARTICULAR FOR OPTOELECTRONIC DEVICES
CUIVRE (I) COMPLEXES, EN PARTICULIER POUR DES DISPOSITIFS OPTOÉLECTRONIQUES

(30) Priorität: 13.05.2011 EP 11166075; 08.07.2011 EP 11173369; 26.08.2011 EP 11179110
(43) Veröffentlichungstag der Anmeldung: 19.03.2014
(73) Patentinhaber: cynora GmbH, 76646 Bruchsal (DE)
(72) Erfinder: BAUMANN, Thomas, 76133 Karlsruhe (DE); GRAB, Tobias, 76133 Karlsruhe (DE); ZINK, Daniel, 76646 Bruchsal (DE)
(74) Vertreter: Hoppe, Georg Johannes
(86) Internationale Anmeldenummer: PCT/EP2012/058957
(87) Internationale Veröffentlichungsnummer: WO 2012/156378

(56) Entgegenhaltungen:
- WO-A1-2010/149748

## Beschreibung

Die Erfindung betrifft Kupfer(I)komplexe der allgemeinen Formel A, insbesondere zur Verwendung in optoelektronischen Bauelementen.

### Einleitung

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese neue Technik basiert auf dem Prinzip der **OLED**s, den **O**rganic **L**ight **E**mitting **D**iodes.

Derartige Bauteile bestehen vorwiegend aus organischen Schichten. Bei einer Spannung von z. B. 5 V bis 10 V treten aus einer leitenden Metallschicht, z. B. aus einer Aluminium-Kathode, Elektronen in eine dünne Elektronen-Leitungsschicht und wandern in Richtung der Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-Licht-Emission ist realisierbar. Auf die Emitterschicht kann gegebenenfalls auch verzichtet werden, wenn die Emittermoleküle sich in der Loch- oder Elektronen-Leitungsschicht befinden.

Entscheidend für den Bau effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metall-organischen Substanzen, den sog. Triplett-Emittern, wesentlich größer sein kann als für rein organische Materialien. Aufgrund dieser Eigenschaft kommt der Weiterentwicklung der metall-organischen Materialien ein wesentlicher Stellenwert zu. Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet.

Kupfer-Komplexe für optoelektronische Anwendungen sind bereits aus der WO 2010/149748 A1 bekannt.

Vor diesem Hintergrund lag der vorliegenden Erfindung die Aufgabe zu Grunde, neue Verbindungen bereitzustellen, die für optoelektronische Bauelemente geeignet sind.

### Beschreibung der Erfindung

Das der Erfindung zu Grunde liegende Problem wird durch die Bereitstellung von Kupfer(I)komplexen der Form Cu₄X*₄(E∩N*)₂ gelöst, die eine Struktur gemäß Formel A aufweisen: 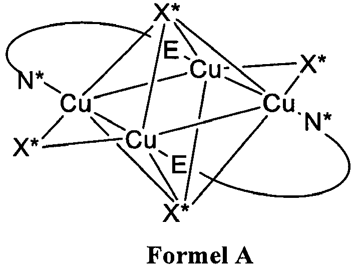 mit:
X* = Cl, Br, I, CN und/oder SCN (also unabhängig voneinander, so dass der Komplex vier gleiche oder vier unterschiedliche Atome X* aufweisen kann);
E = R₂As und/oder R₂P,
N*∩E = zweibindige Liganden mit E = Phosphanyl/Arsenyl-Rest der Form R₂E (R = Alkyl, Aryl, Alkoxyl, Phenoxyl, Amid); N* = Imin-Funktion. Bei "∩" handelt es sich um ein Kohlenstoffatom. Insbesondere handelt es sich bei E um eine Ph₂P-Gruppe (Ph = Phenyl), die Imin-Funktion ist Bestandteil eines N-heteroaromatischen 5- oder 6-Rings wie Oxazol, Imidazol, Thiazol, Isoxazol, Isothiazol, Pyrazol, 1,2,3-Triazol, 1,2,3-Oxadiazol, 1,2,5-Oxadiazol, 1,2,3-Thiadiazol, 1,2,5-Thiadiazol, Pyridin, Pyrimidin, Triazin, Pyrazin oder Pyridazin. "∩" ist ebenfalls Bestandteil dieser aromatischen Gruppe. Das Kohlenstoffatom befindet sich sowohl direkt benachbart zum Imin-Stickstoff-Atom als auch zum E-Atom. N*∩E kann optional substituiert sein, insbesondere mit Gruppen, die die Löslichkeit des Kupfer(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Ein erfindungsgemäßer Kupfer(I)komplex besteht bevorzugt aus zwei identischen Liganden N*∩E, was den Syntheseaufwand und damit die Kosten der Herstellung vermindert. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Kupfer(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Kupfer(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden N*∩E um Oxazol, Imidazol, Thiazol, Isoxazol, Isothiazol, Pyrazol, 1,2,3-Triazol, 1,2,3-Oxadiazol, 1,2,5-Oxadiazol, 1,2,3-Thiadiazol, 1,2,5-Thiadiazol, Pyridin, Pyrimidin, Triazin, Pyrazin und/oder Pyridazin, die jeweils substituiert sein können, wie hierin beschrieben.

Bevorzugt handelt es sich bei dem Liganden N*∩E um folgende Liganden:

| | |
|---|---|
| 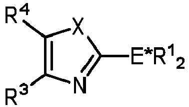 | X= NR²: 1R²-2E*R¹₂-4R³-5R⁴-1*H*-Imidazol |
| | X = O: 2E*R¹₂-4R³-5R⁴-Oxazol |
| | X = S: 2E*R¹₂-4R³-5R⁴-Thiazol |
| 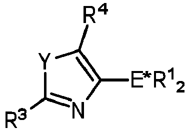 | Y = NR²: 1R²-4E*R¹₂-2R³-5R⁴-1*H*-Imidazol |
| | Y = O: 4E*R¹₂-2R³-5R⁴-Oxazol |
| | Y = S: 4E*R¹₂-2R³-5R⁴-Thiazol |
| | |
| 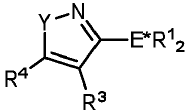 | Y = NR²: 1R²-3E*R¹₂-4R³-5R⁴-1*H*-Pyrazol |
| | Y = 0: 3E*R¹₂-4R³-5R⁴-Isoxazol |
| | Y = S: 3E*R¹₂-4R³-5R⁴-Isothiazol |
| | |
| 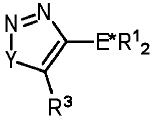 | Y = NR²: 1R²-4E*R¹₂-5R³-1*H*-1,2,3-Triazol |
| | Y = 0: 4E*R¹₂-5R³-1,2,3-Oxadiazol |
| | Y = S: 4E*R¹₂-5R³-1,2,3-Thiadiazol |
| | |
| 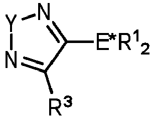 | Y = NR²: 2R²-4E*R¹₂-5R³-2*H*-1,2,3-Triazol |
| | Y = 0: 3E*R¹₂-4R³-1,2,5-Oxadiazol |
| | Y = S: 3E*R¹₂-4R³-1,2,5-Thiadiazol |
| 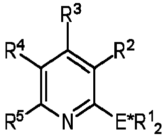 | 2E*R¹₂-3R²-4R³-5R⁴-6R⁵-Pyridin |
| 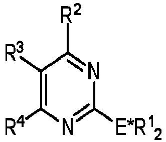 | 2E*R¹₂-4R²-5R³-6R⁴-Pyrimidin |
| 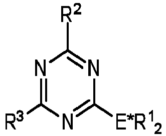 | 2E*R¹₂-4R²-6R³-1,3,5-Triazin |
| 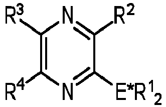 | 2E*R¹₂-3R²-5R³-6R⁴-Pyrazin |
| 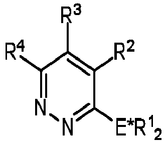 | 3E*R¹₂-4R²-5R³-6R⁴-Pyridazin |
| 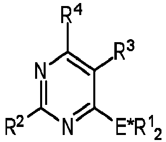 | 4E*R¹₂-2R²-5R³-6R⁴-Pyrimidin |

mit
X = O oder NR²
Y = O oder NR² oder S
E* = As oder P
R1-R5 können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen. R2-R5 können optional auch zu annelierten Ringsystemen führen.

Besonders bevorzugt handelt es sich bei dem Liganden N*∩E um folgende Liganden:

| | |
|---|---|
| 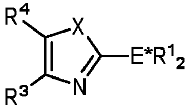 | X = NR²: 1R²-2E*R¹₂-4R³-5R⁴-1*H*-Imidazol |
| | X = O: 2E*R¹₂-4R³-5R⁴-Oxazol |

wobei die verwendeten Symbole oben beschrieben sind.

Die Erfindung betrifft auch ein Verfahren zur Herstellung eines erfindungsgemäßen Kupfer(I)komplexes. Dieses erfindungsgemäße Verfahren weist den Schritt des Durchführens einer Reaktion von N*∩E mit Cu(I)X* auf,
wobei
X* = Cl, Br, I, CN, und/oder SCN (unabhängig voneinander)
N*∩E = ein zweibindiger Ligand mit
E = Phosphanyl/Arsenyl-Rest der Form R₂E (mit R = Alkyl, Aryl, Alkoxyl, Phenoxyl, oder Amid);
N* = Imin-Funktion, die Bestandteil eines N-heteroaromatischen 5- oder 6-Rings wie Oxazol, Imidazol, Thiazol, Isoxazol, Isothiazol, Pyrazol, 1,2,3-Triazol, 1,2,3-Oxadiazol, 1,2,5- Oxadiazol, 1,2,3-Thiadiazol, 1,2,5-Thiadiazol, Pyridin, Pyrimidin, Triazin, Pyrazin und/oder Pyridazin.
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet.

Der optional am Liganden N*∩E vorhandene mindestens eine Substituent zur Erhöhung der Löslichkeit des Komplexes in organischen Lösungsmitteln ist weiter unten beschrieben.

Die Reaktion wird bevorzugter Weise in Dichlormethan (DCM) durchgeführt. Durch die Zugabe von Diethylether zum gelösten Produkt kann ein Feststoff gewonnen werden. Letzteres kann durch Fällung oder Eindiffusion oder in einem Ultraschall-Bad durchgeführt werden.

Bei der Reaktion von 2 Einheiten zweizähnigen P∩N*-Liganden (P∩N* = Phosphan-Ligand, Definition s. u.) mit 4 Einheiten Cu(I)X* (X* = Cl, Br, I, CN, SCN), bevorzugt in Dichlormethan (DCM), bevorzugt bei Raumtemperatur, entsteht der vierkernige 4:2-Komplex Cu₄X*₄(P∩N*)₂, in dem die vier Cu-Atome die Grundfläche eines Oktaeders und zwei Halogen-Ionen deren Spitze ausbilden (Gl. 1). Die anderen beiden Halogen-Ionen überbrücken zwei gegenüberliegende Seiten der Oktaeder-Grundfläche, während die zwei P∩N*-Liganden die zwei anderen gegenüberliegenden Seiten der Oktaeder-Grundfläche in chelatisierender Form sowohl mit dem N- als auch dem P-Atom überbrücken und die Cu-Atome somit koordinativ absättigen.

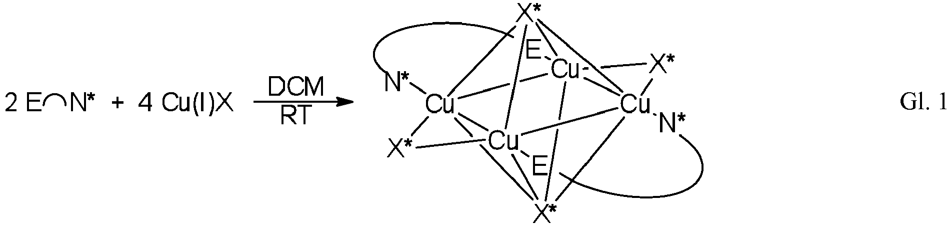

Somit ist der Komplex in nur einem Schritt durch Umsetzung von Cu(I)X* mit dem zweizähnigen P∩N*-Liganden zugänglich. Der Komplex kann durch Fällen mit Et₂O als weißes mikrokristallines Pulver isoliert werden. Einkristalle können durch langsames Eindiffundieren von Et₂O in die Reaktionslösung erhalten werden. Die Identitäten der Komplexe wurden eindeutig durch Elementar- und Röntgenstrukturanalysen belegt.

Hierbei handelt es sich um die oben aufgeführte allgemeine Formel A. Die zweizähnigen E∩N*-Liganden können unabhängig voneinander mindestens einen Substituenten umfassen: Die Substituenten können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen. Die Substituenten können optional auch zu annelierten Ringsystemen führen.

### Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substitutenten R2-R5 so gewählt werden, dass sie eine Abstimmung der Löslichkeiten erlauben. Folgende Möglichkeiten zur Auswahl entsprechender Substituenten sind gegeben:

### Löslichkeit in unpolaren Medien

Unpolare Substitutenten R2-R5 erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ - und (-CF₂-O)ₙ- (n = 2 - 500). Weitere unpolare Gruppen sind: Ether -OR*, Thioether -SR*, unterschiedlich substituierte Silane R*₃Si- (R* = Alkyl oder Aryl), Siloxane R*₃Si-O-, Oligosiloxane R**(-R₂Si-O)ₙ- (R** = R*, n = 2 - 20), Polysiloxane R**(-R*₂Si-O)ₙ (n > 20); Oligo/polyphosphazene R**(-R*₂P=N-)ₙ- (n = 1 - 200).

### Löslichkeit in polaren Medien

Polare Substitutenten R2-R5 erhöhen die Löslichkeit in polaren Lösungsmitteln. Diese können sein:
- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze):
   -COOH, -P(O)(OH)₂, -P(S)(OH)₂, -S(O)(OH)₂, -COOR*, -P(O)(OR*)₂, -P(S)(OR*)₂,-S(O)(OR*)₂, -CONHR*, -P(O)(NR*₂)₂, -P(S)(NR*₂)₂, -S(O)(NR*₂)₂
- Sulfoxide: -S(O)R*, -S(O)₂R*
- Carbonylgruppen: -C(O)R*
- Amine: -NH₂, -NR*₂, -N(CH₂CH₂OH)₂,
- Hydroxylamine =NOR*
- Oligoester, -O(CH₂O-)ₙ, -O(CH₂CH₂O-)ₙ (n = 2 - 200)
- Positiv geladene Substituenten: z. B. Ammonium-Salze -N⁺R*₃X⁻, Phosphonium-Salze-P⁺R*3X⁻
- Negativ geladene Substituenten, z. B. Borate -(BR*₃)⁻, Aluminate -(AlR*₃)⁻ (als Anion kann ein Alkalimetal oder Ammoniumion fungieren).

Um die Löslichkeit der erfindungsgemäßen Kupfer(I)komplexe in organischen Lösungsmitteln zu verbessern, ist mindestens eine der Strukturen N*∩E in bevorzugter Weise mit mindestens einem Substituenten substituiert. Der Substituent kann ausgewählt sein aus der Gruppe bestehend aus:
- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form (-OCH₂CH₂O-)ₙ, mit n < 500. Beispiele hierfür sind Polyethylenglykole (PEG), die als chemisch inerte, wasserlösliche und nicht-toxische Polymere mit einer Kettenlänge von 3-50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C6-Einheit, verzweigt oder unverzweigt oder zyklisch, erreicht. Die Substitution zum Beispiel mit einer linearen C6-Kette (siehe unten) führt zu einer sehr guten Löslichkeit in z. B. Dichlormethan und zur guten Löslichkeit in Dichlorbenzol oder Chlorbenzol.

Optional kann das Darstellungsverfahren den Schritt umfassen, dass mindestens ein Ligand N*∩E mit mindestens einem Substituenten zur Erhöhung der Löslichkeit in dem gewünschten organischen Lösungsmittel substituiert wird, wobei der Substituent in einer Ausführungsform der Erfindung ausgewählt sein kann aus o.g. Gruppen.

Erfindungsgemäß sind auch Kupfer(I)komplexe, die durch ein derartiges Syntheseverfahren herstellbar sind.

Die Kupfer(I)komplexe der Formel A können erfindungsgemäß als Emitter-Materialien in einer Emitterschicht eines Licht-emittierenden optoelektronischen Bauelements eingesetzt werden. Die optoelektronischen Bauelemente sind bevorzugt die folgenden: Organischen Licht-emittierenden Bauteilen (OLEDs), Licht-emittierenden elektrochemischen Zellen, OLED-Sensoren (insbesondere in nicht hermetisch nach außen abgeschirmten Gas- und Dampf-Sensoren), organischen Solarzellen, Organische Feldeffekttransistoren, organische Laser und Down-Konversions-Elemente.

Der Anteil des Kupfer(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Kupfer(I)komplexes in der Emitter- oder Absorber-Schicht 1 % bis 99 %.

Bei einem Verfahren zur Herstellung eines optoelektronischen Bauelements, bei dem ein erfindungsgemäßer Kupfer(I)komplex verwendet wird, kann das Aufbringen eines derartigen Kupfer(I)komplexes auf ein Trägermaterial erfolgen. Dieses Aufbringen kann nass-chemisch, mittels kolloidaler Suspension oder mittels Sublimation erfolgen.
Ein weiterer Aspekt der Erfindung betrifft ein Verfahren zur Veränderung der Emissions- und/oder Absorptionseigenschaften eines elektronischen Bauelements. Dabei wird ein erfindungsgemäßer Kupfer(I)komplexe in ein Matrixmaterial zur Leitung von Elektronen oder Löchern in ein optoelektronisches Bauelement eingebracht.

Ein weiterer Aspekt der Erfindung betrifft eine Verwendung eines erfindungsgemäßen Kupfer(I)komplexes, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

Die Erfindung betrifft in einem weiteren Aspekt einige zweizähnige Liganden der Formel B, insbesondere zur Herstellung eines Kupferkomplexes der Formel A, sowie das Verfahren zur Herstellung eines erfindungsgemäßen Liganden.

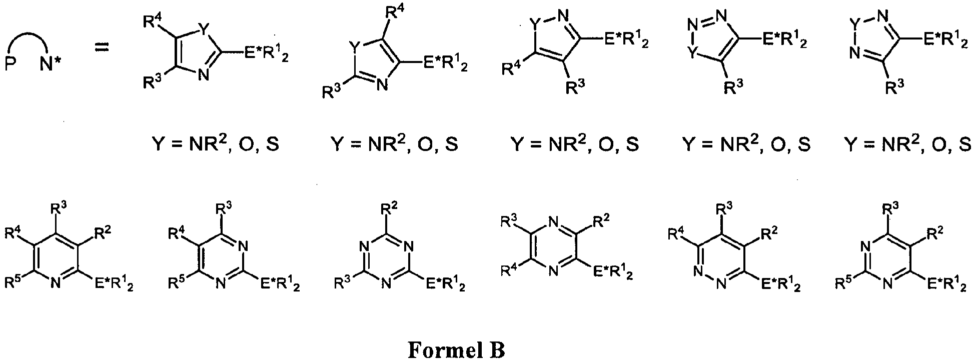

Die in Formel B verwendeten Symbole entsprechen den für Formel A verwendeten Symbolen, die hierin beschrieben sind.

Das Verfahren zur Herstellung eines zweizähnigen Liganden der Formel B wird gemäß dem nachfolgend dargestellten Schema durchgeführt:

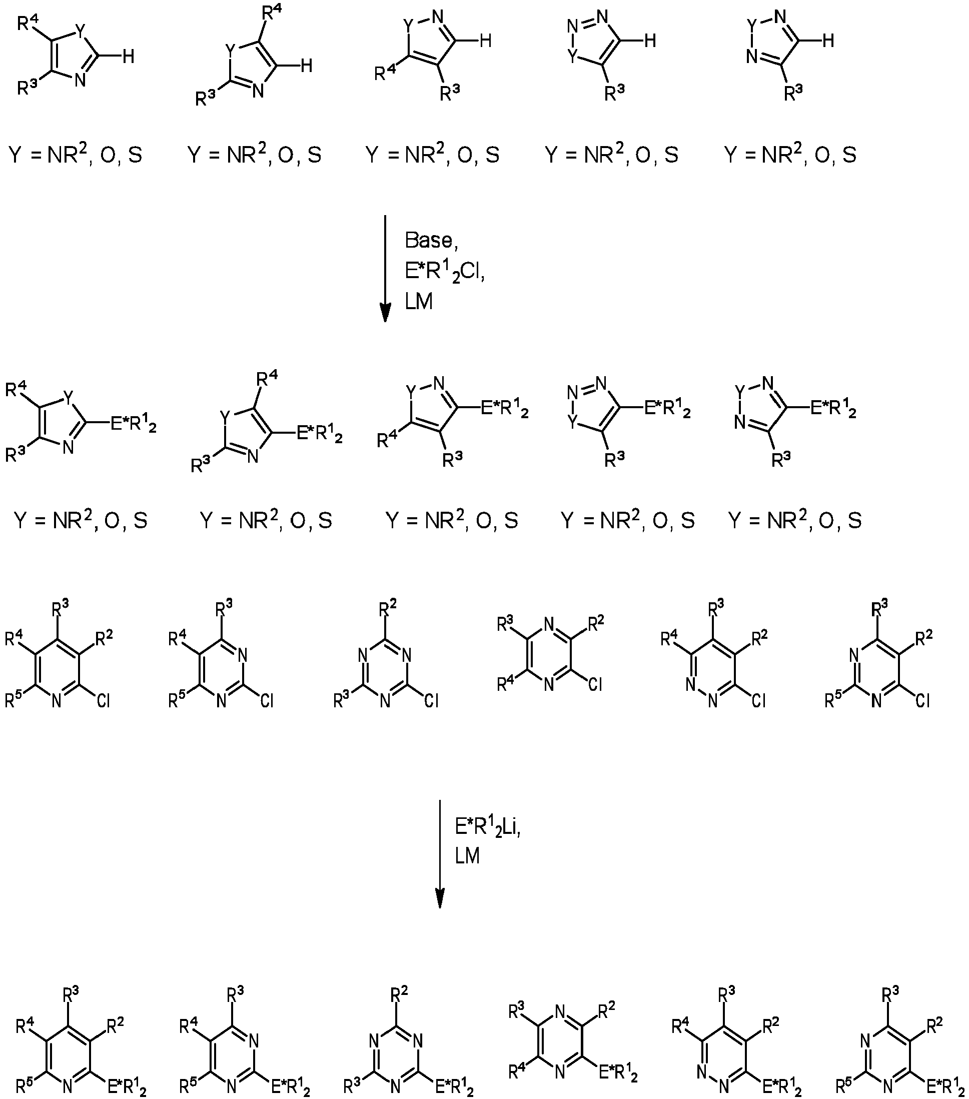

Bevorzugt wird das Verfahren zur Herstellung eines zweizähnigen Liganden der Formel B gemäß einem der nachfolgend dargestellten Schemata durchgeführt:

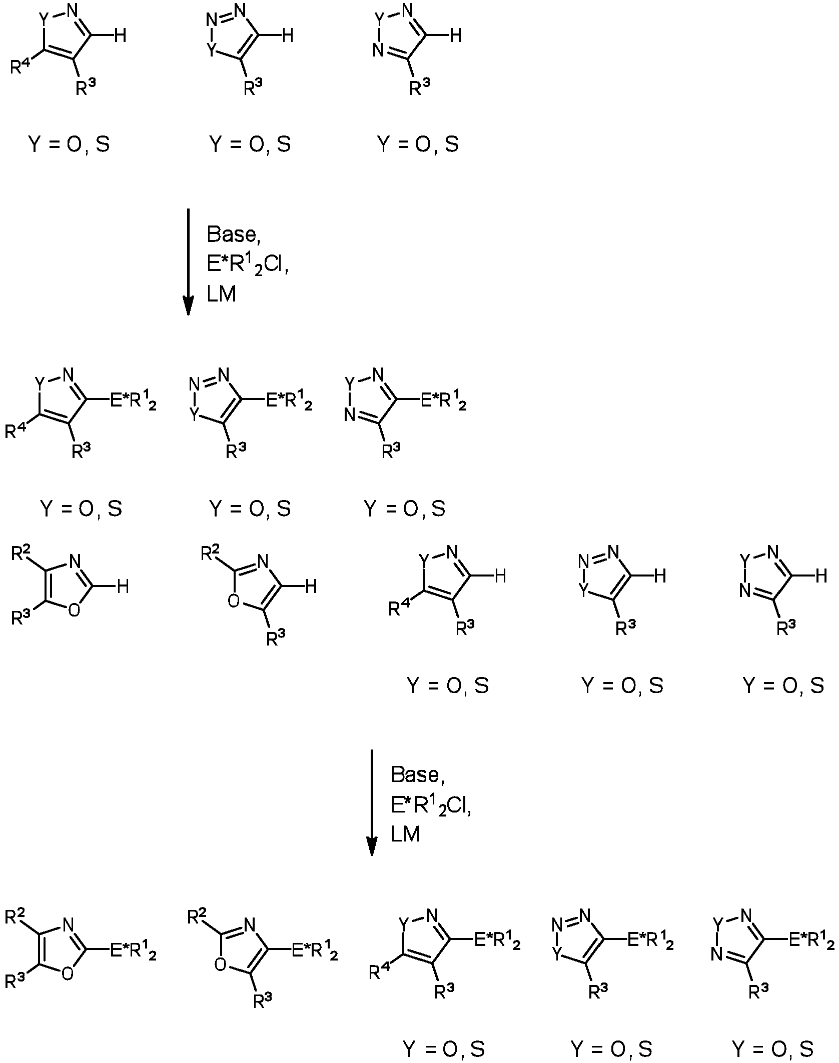

Die oben verwendeten Symbole entsprechen den für Formel A verwendeten Symbolen, die hierin beschrieben sind.

### Beispiele:

In den hier gezeigten Beispielen ist der Ligand E∩N* der allgemeinen Formel A ein Ligand P∩N* (mit E = Ph₂P)

Für die Herstellung der Kupferkomplexe wurden die zweizähnigen Phosphanliganden Oxazol, Imidazol, Thiazol, Isoxazol, Isothiazol, Pyrazol, 1,2,3-Triazol, 1,2,3-Oxadiazol, 1,2,5-Oxadiazol, 1,2,3-Thiadiazol, 1,2,5-Thiadiazol, Pyridin, Pyrimidin, Triazin, Pyrazin, Pyridazin entsprechend der obigen Beschreibung verwendet:

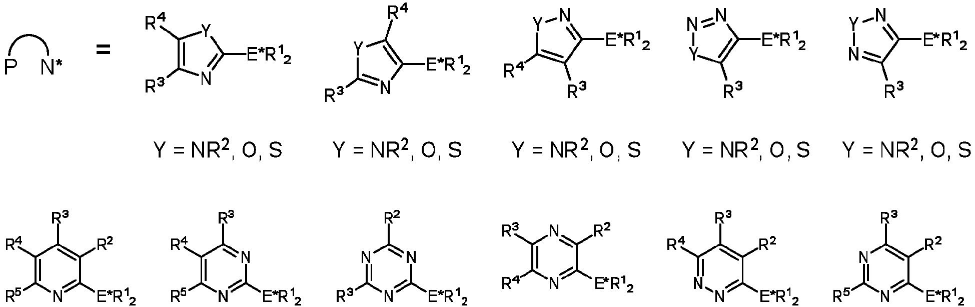

Die Liganden wurden im Falle der Imidazole, Thiazole und 1*H*-1,2,3-Triazole und Pyridin, Pyrimidin, Triazin, Pyrazin, Pyridazin gemäß Literaturvorschriften hergestellt, während alle anderen Phosphanliganden bisher nicht bekannt sind und somit nach einer neuen Synthese dargestellt wurden.

### Allgemeine Synthese der Phosphanliganden

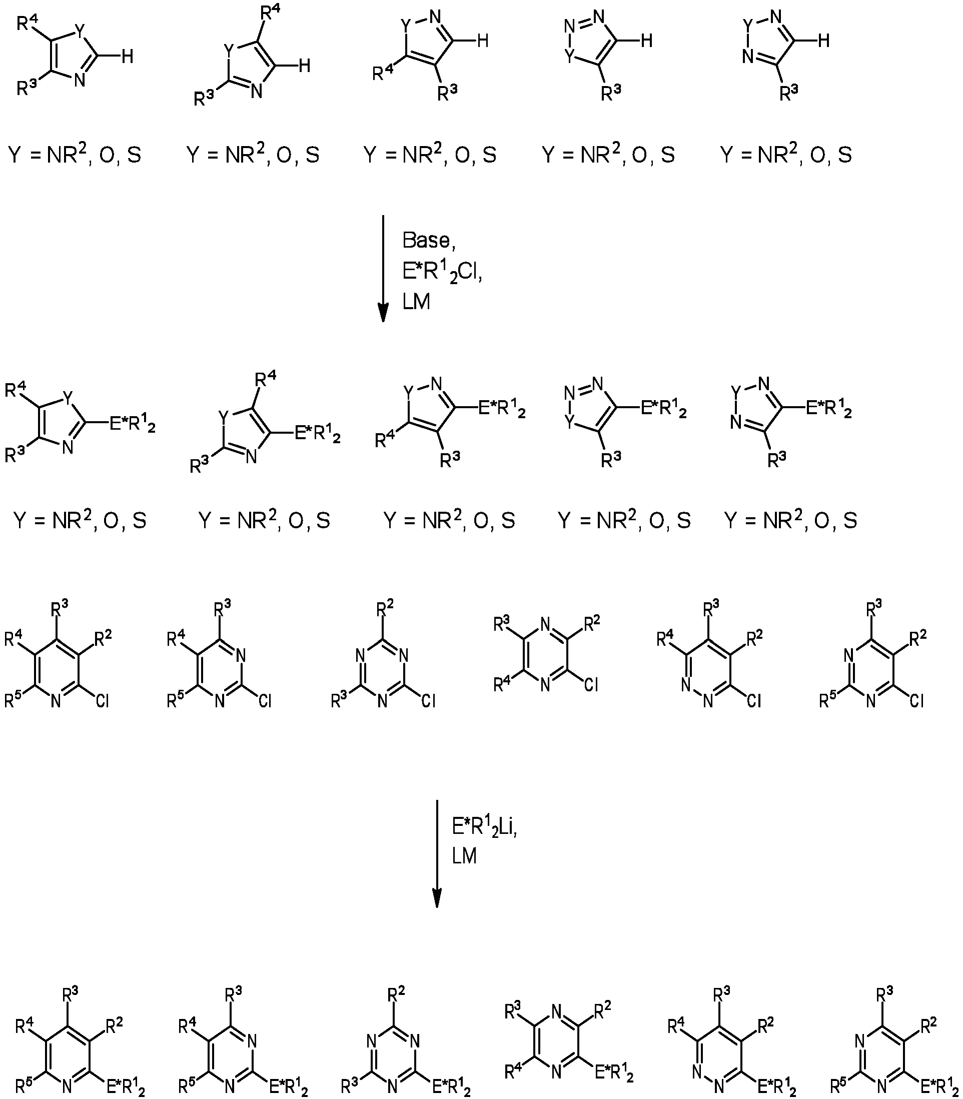

Die Identitäten der Liganden wurden eindeutig durch NMR-Spektroskopie und Massenspektrometrie belegt.

### Beispiele für Komplexe der Form Cu₄X*₄(P∩N*)₂

### I. P∩N* = Ph₂Pbenzimidazol, 1a-e: Cu₄I₄(Ph₂Pbenzimidazol)₂, 2a-e

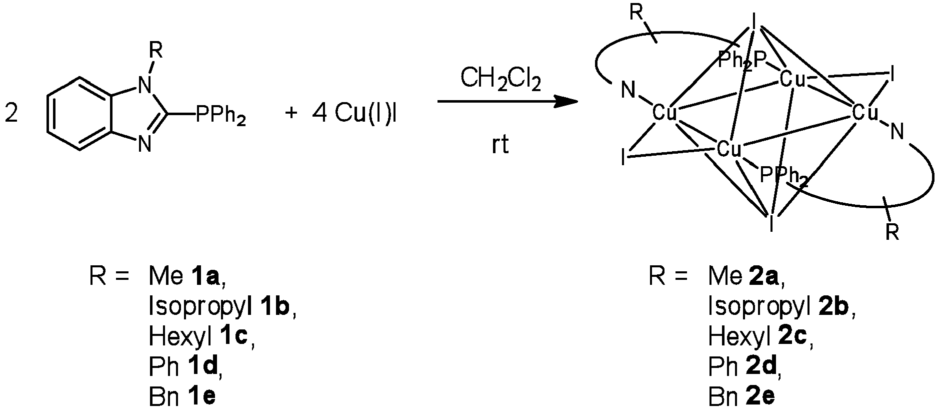

Bei den Verbindungen **2a-e** handelt es sich um weiße, feinkristalline Feststoffe.

Charakterisierung:
Elementaranalyse:

| | |
|---|---|
| **2a** (R = Me) | ber.: C 34.45; H 2.46; N 4.02 |
| | gef.: C 34.23; H 2.42; N 3.85 |
| **2b** (R = Isopropyl) | ber.: C 34.10; H 2.86; N 3.46 (x1 CH₂Cl₂) |
| | gef.: C 34.34; H 2.85; N 3.41 |
| **2c** (R = Hexyl) | ber.: C 37.82; H 3.48; N 3.46 (x1 CH₂Cl₂) |
| | gef.: C 37.99; H 3.43; N 3.31 |
| **2d** (R = Ph) | ber.: C 37.58; H 2.51; N 3.40 (x1.5 CH₂Cl₂) |
| | gef.: C 37.56; H 2.51; N 3.25 |

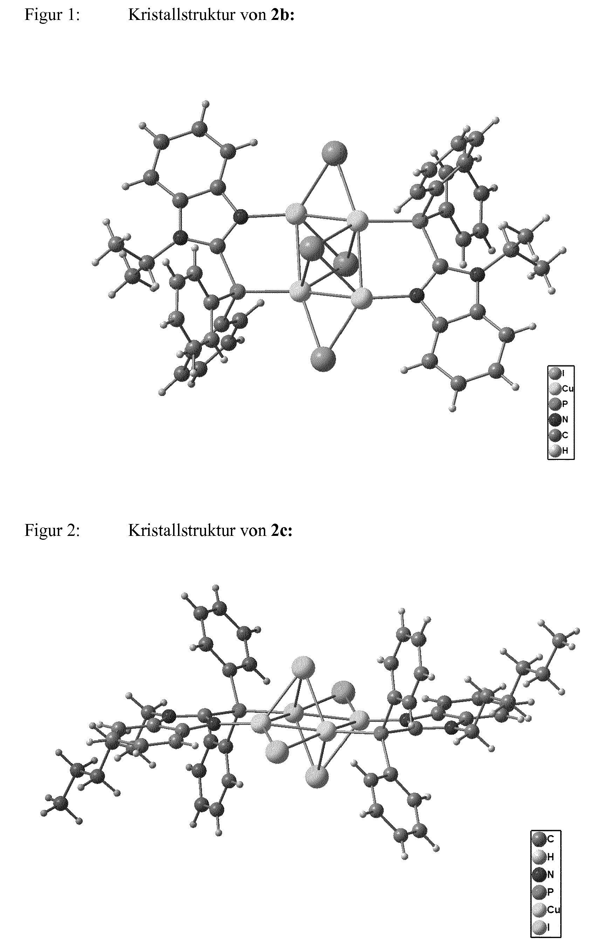

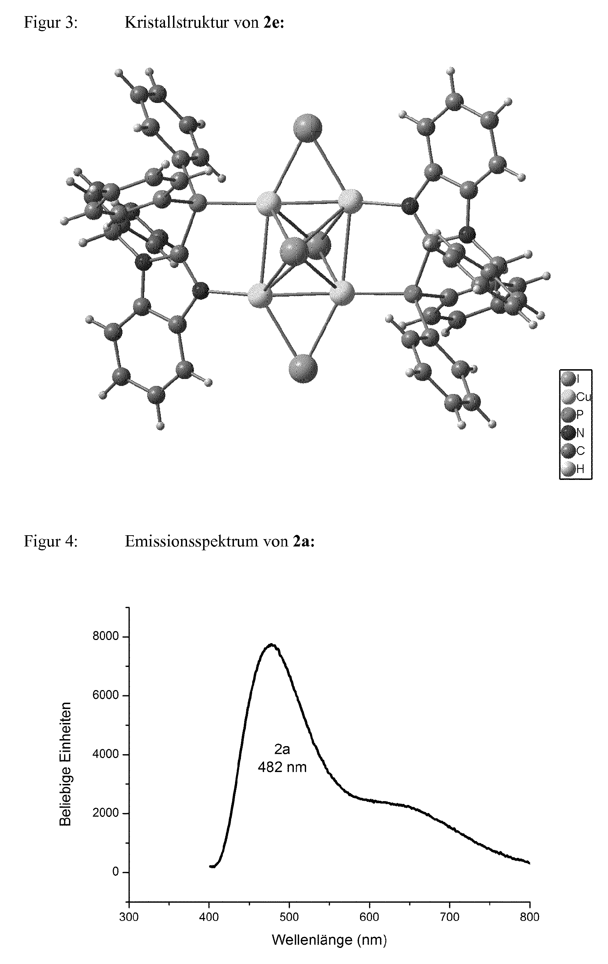

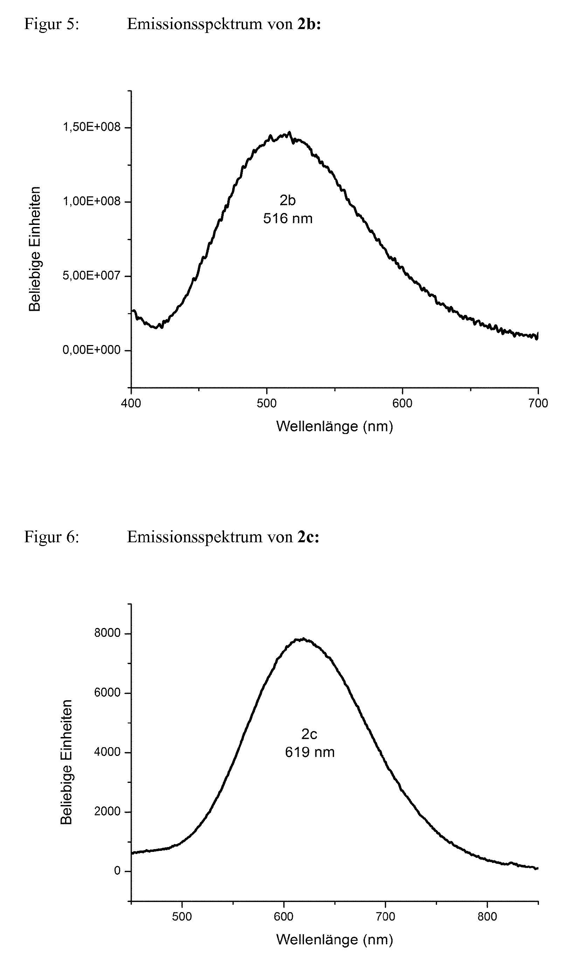

Die Kristallstrukturen von **2b, 2c, 2e** sind in Fig. 1-3 dargestellt.
Die Emissionsspektren von **2a-c, 2e** sind in Fig. 4-7 gezeigt.

### II. P∩N* = Ph₂PMe₂benzimidazol, 3a-e: Cu₄I₄(Ph₂PMe₂benzimidazol)₂, 4a-e

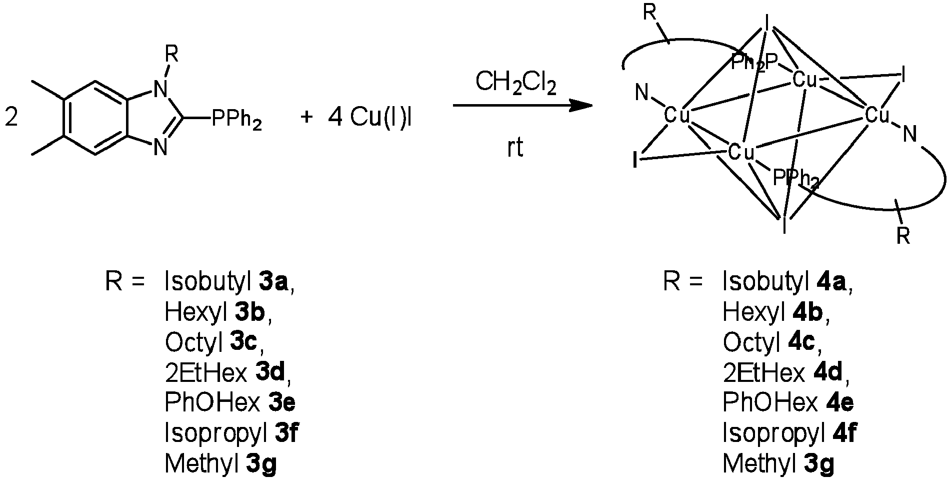

Bei den Verbindungen **4a-g** handelt es sich um weiße, feinkristalline Feststoffe.

Charakterisierung:
Elementaranalyse:

| | |
|---|---|
| **4a** (R = Isobutyl) | ber.: C 37.82; H 3.48; N 3.46 (x1 CH₂Cl₂) |
| | gef.: C 37.54; H 3.52; N 3.44 |
| **4b** (R = Hexyl) | ber.: C 40.77; H 3.93; N 3.52 |
| | gef.: C 41.07; H 3.97; N 3.31 |
| **4d** (R = 2EtHex) | ber.: C 42.30; H 4.28; N 3.40 |
| | gef.: C 42.37; H 4.23; N 3.30 |
| **4e** (R = PhOHex) | ber.: C 44.66; H 3.97; N 3.16 |
| | gef.: C 44.60; H 3.96; N 2.92 |
| **4f** (R = Isopropyl) | ber.: C 35.82; H 3.25; N 3.34 (x2 CH₂Cl₂) |
| | gef.: C 36.22; H 3.13; N 3.49 |
| **4g** (R = Methyl) | ber.: C 35.20; H 2.89; N 3.65 (x1 CH₂Cl₂) |
| | gef.: C 35.28; H 2.77; N 3.67 |

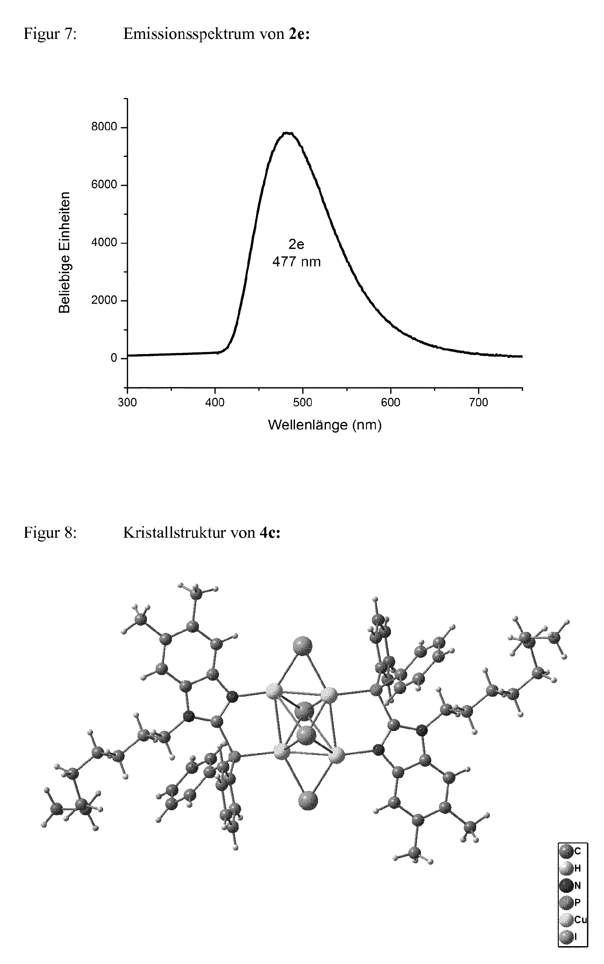

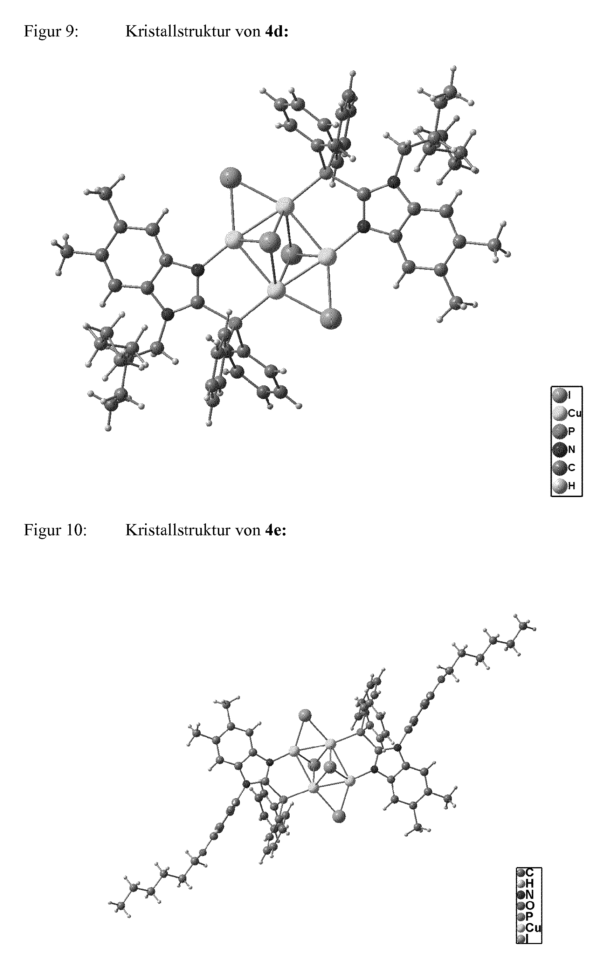

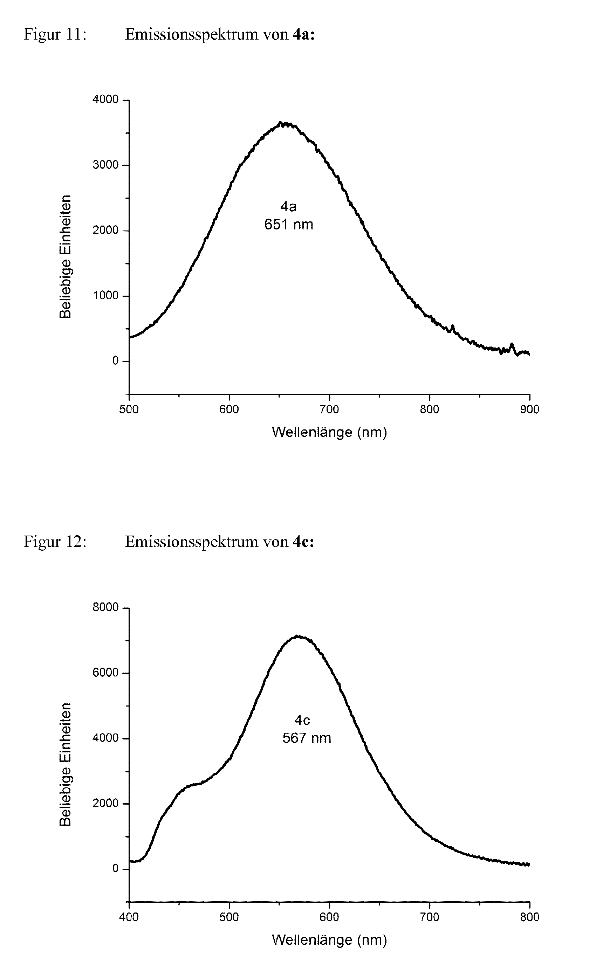

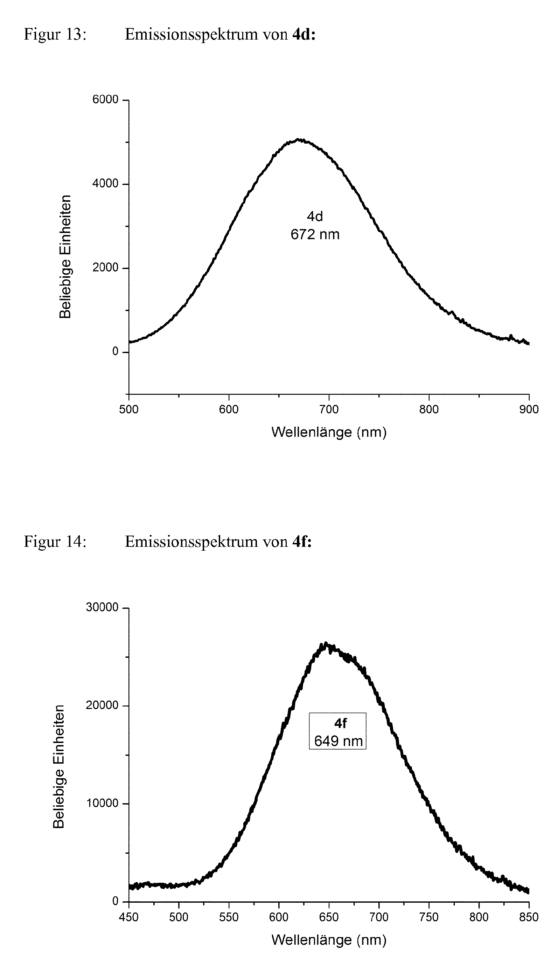

Die Kristallstrukturen von **4c, 4d, 4e** sind in Fig. 8-10 dargestellt.
Die Emissionsspektren von **4a, 4c, 4d, 4f, 4g** sind in Fig. 11-15 gezeigt.

### III. P∩N* = Ph₂Phenimidazol, 5a-d: Cu₄I₄(Ph₂Phenimidazol)₂, 6a-d

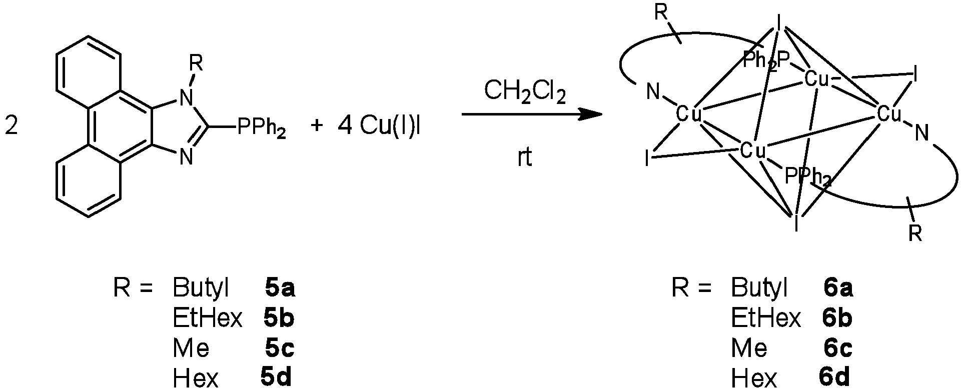

Bei den Verbindungen **6a-d** handelt es sich um weiße, feinkristalline Feststoffe.

Charakterisierung:
Elementaranalyse:

| | |
|---|---|
| **6a** (R = Butyl) | ber.: C 41.58; H 3.16; N 3.03 (x2 CH₂Cl₂) |
| | gef.: C 41.34; H 3.17; N 2.76 |
| **6b** (R = 2EtHexl) | ber.: C 46.94; H 3.94; N 3.13) |
| | gef.: C 47.02; H 3.91; N 3.02 |
| **6c** (R = Me) | ber.: C 40.76; H 2.64; N 3.34 (x1 CH₂Cl₂) |
| | gef.: C 40.64; H 2.45; N 3.51 |
| **6d** (R = Hex) | ber.: C 45.69; H 3.60; N 3.23 (x2 CH₂Cl₂) |
| | gef.: C 45.54; H 3.49; N 3.08 |

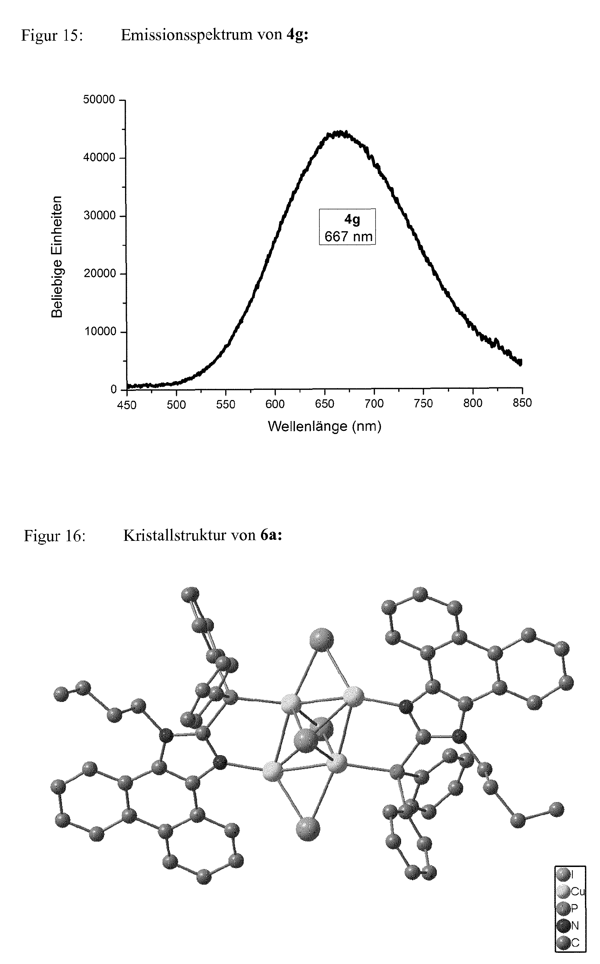

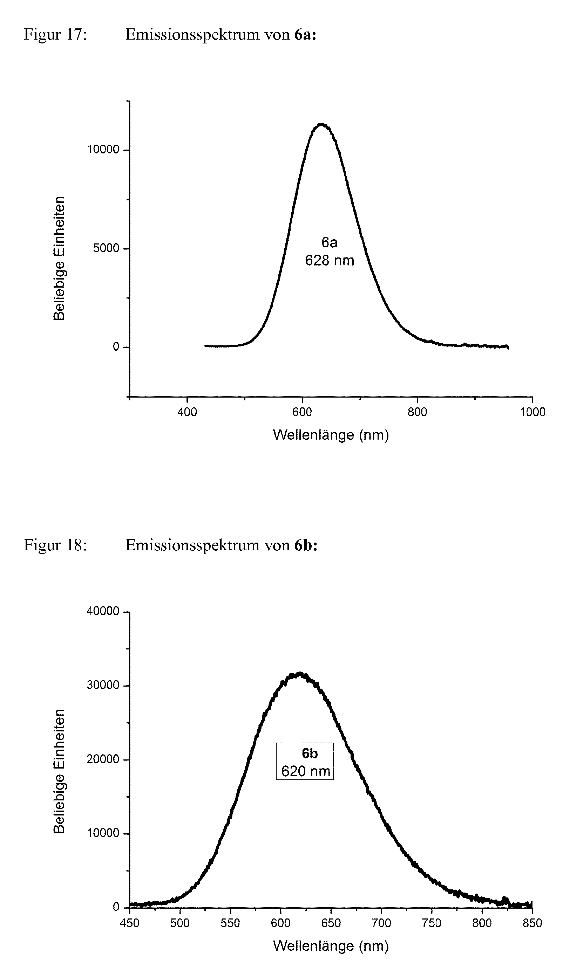

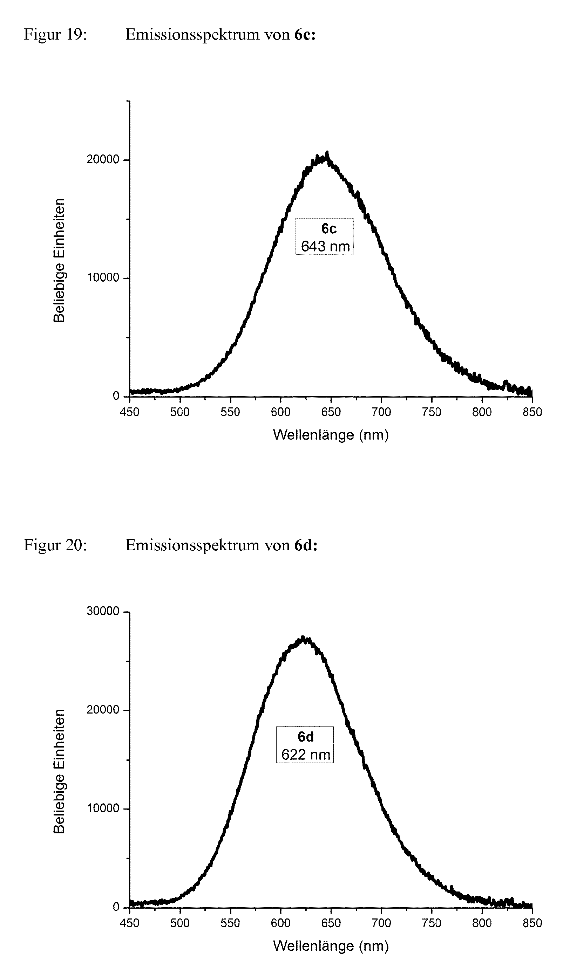

Die Kristallstruktur von **6a** ist in Fig. 16 dargestellt.
Die Emissionsspektren von **6a-d** sind in Fig. 17-20 gezeigt.

### IV. P∩N* = Ph₂PImidazol, 7a-c: Cu₄I₄(Ph₂PImidazol)₂, 8a-c

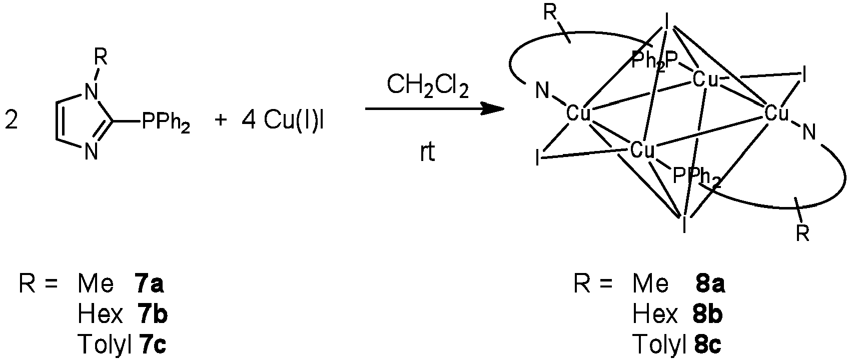

Bei den Verbindungen **8a-c** handelt es sich um weiße, feinkristalline Feststoffe.

Charakterisierung:
Elementaranalyse:

| | |
|---|---|
| **8a** (R = Me) | ber.: C 28.74; H 2.34; N 4.06 (x1 CH₂Cl₂) |
| | gef.: C 28.76; H 2.31; N 4.10 |
| **8b** (R = Pent) | ber.: C 33.57; H 3.27; N 3.87 (x1/2 CH₂Cl₂) |
| | gef.: C 33.51, H 3.18; N 3.80 |
| **8c** (R = Tolyl) | ber.: C 35.89; H 2.64; N 3.76 (x1/2 CH₂Cl₂) |
| | gef.: C 35.78; H 2.58; N 3.60 |

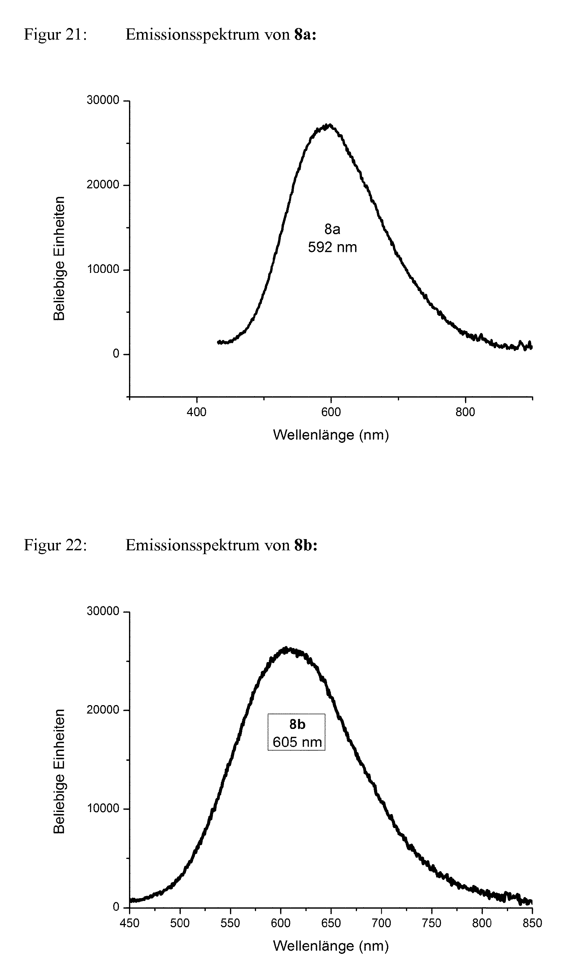

Die Emissionsspektren von **8a-c** sind in Fig. 21-23 gezeigt.

### V. P∩N* = Ph₂PBenzoxazol, 9a: Cu₄I₄(Ph₂PBenzoxazol)₂, 10a

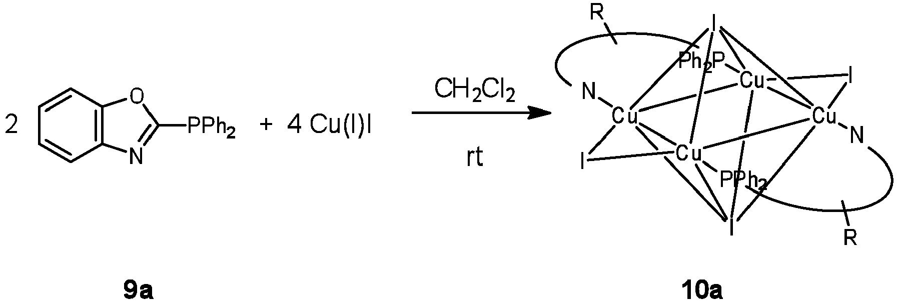

Bei der Verbindung **10a** handelt es sich um einen weißen, feinkristallinen Feststoff.

Charakterisierung:
Elementaranalyse:

| | |
|---|---|
| **10a** | ber.: C 33.35; H 2.06; N 2.05 |
| | gef.: C 33.21; H 2.09; N 1.79 |

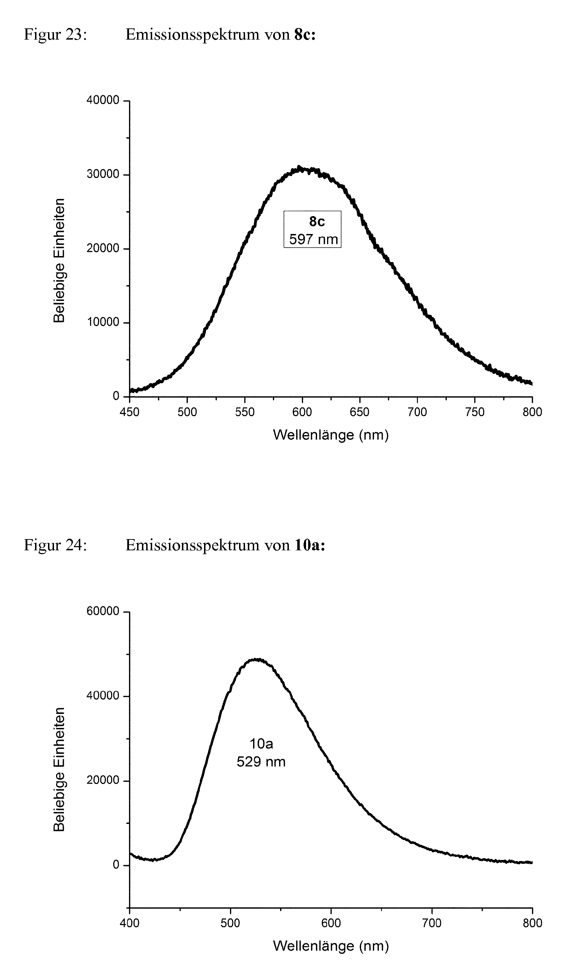

Das Emissionsspektrum von **10a** ist in Fig. 24 gezeigt.

### VI. P∩N* = Ph₂PPh₂triazol, 11a: Cu₄I₄(Ph₂PPh₂triazol)₂, 12a

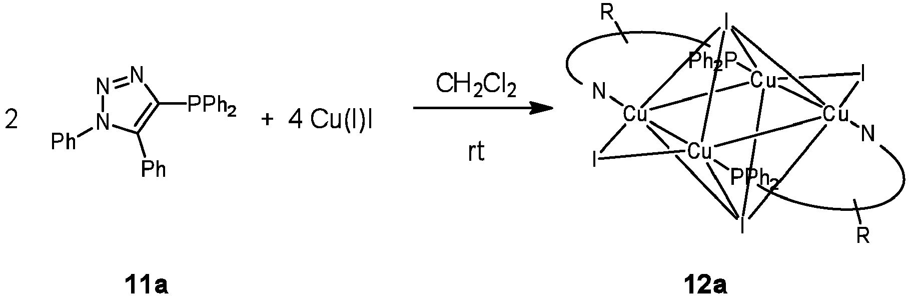

Bei der Verbindung **12a** handelt es sich um einen weißen, feinkristallinen Feststoff.

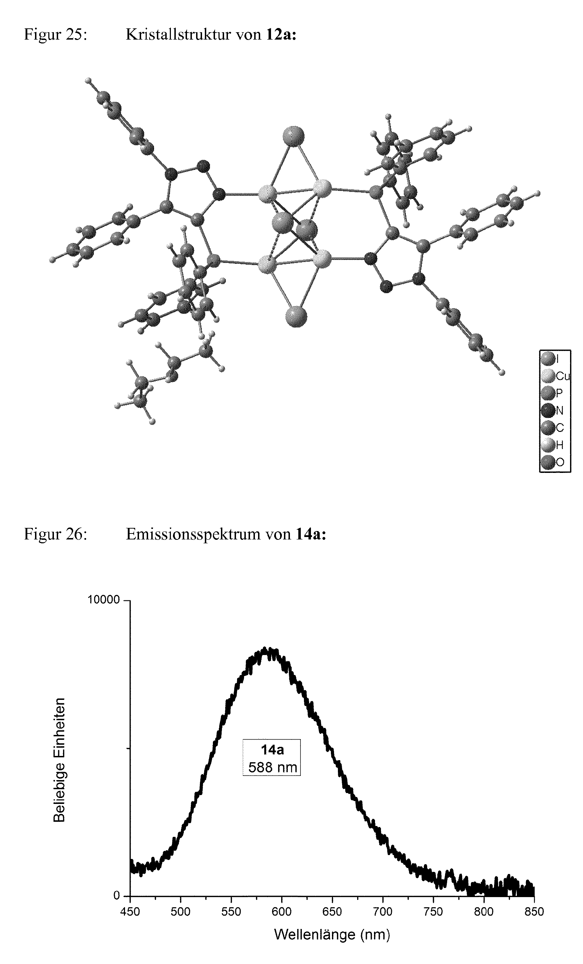

Charakterisierung:
Die Kristallstruktur von **12a** ist in Fig. 25 dargestellt.

### VII. P∩N* = Ph₂P-1,2,4-Triazol, 13a-e: Cu₄I₄(Ph₂P-1,2,4-Triazol)₂, 14a-e

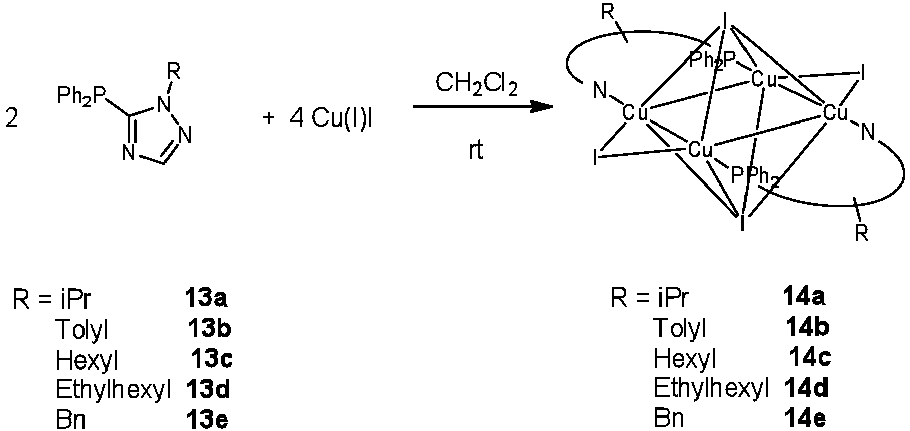

Bei den Verbindungen **14a-e** handelt es sich um weiße, feinkristalline Feststoffe.

Charakterisierung:
Elementaranalyse:

| | |
|---|---|
| **14a** (R = iPr) | ber.: C 31.12; H 2.97; N 6.05 (x1/2 Et₂O) |
| | gef.: C 31.02; H 2.83; N 6.16 |
| **14b** (R = Tolyl) | ber.: C 34.24; H 2.50; N 5.46 (x1/2 CH₂Cl₂) |
| | gef.: C 34.36; H 2.45; N 5.61 |
| **14c** (R = Pent) | ber.: C 32.40; H 3.15; N 5.97 |
| | gef.: C 32.79; H 3.11; N 5.94 |
| **14d** (R = 2EtHex) | ber.: C 35.40; H 3.78; N 5.44 |
| | gef.: C 35.15; H 3.70; N 5.52 |
| **14e** (R = Bn) | ber.: C 34.83; H 2.51; N 5.80 |
| | gef.: C 35.17; H 2.43; N 5.77 |

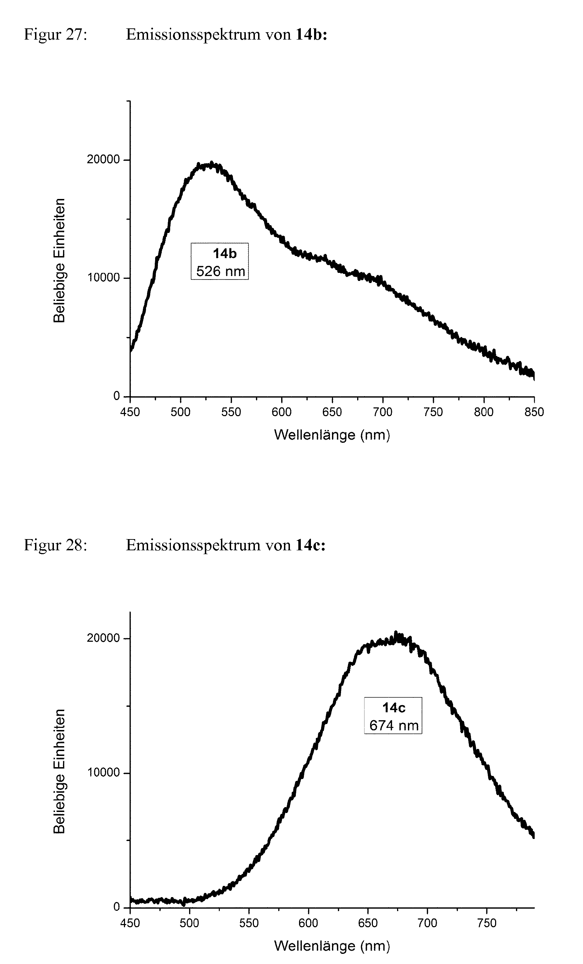

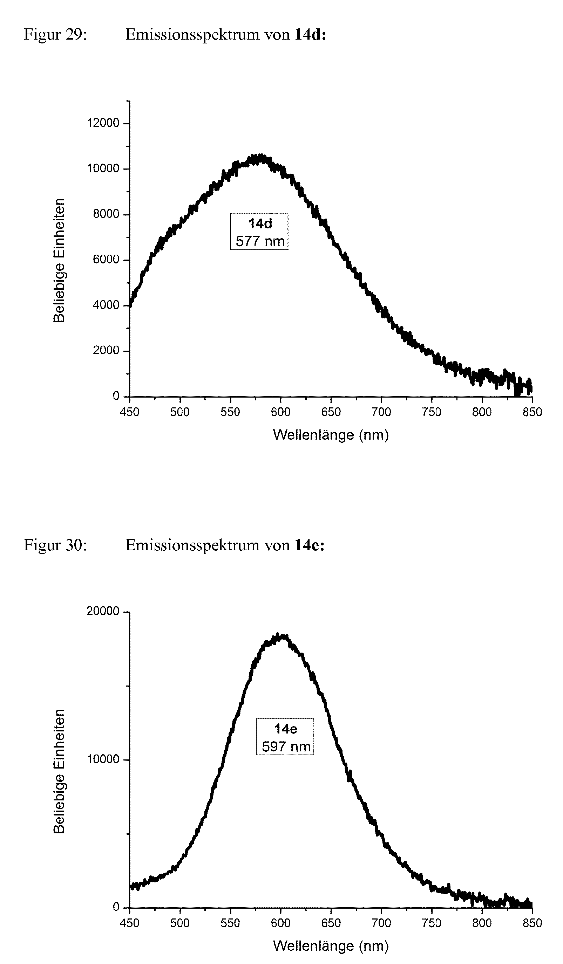

Die Emissionsspektren von **14a-e** sind in Fig. 26-30 gezeigt.

### VIII. P∩N* = Ph2PPh₂Oxazol, 15a: Cu₄I₄(Ph2PPh₂Oxazol)₂, 16a

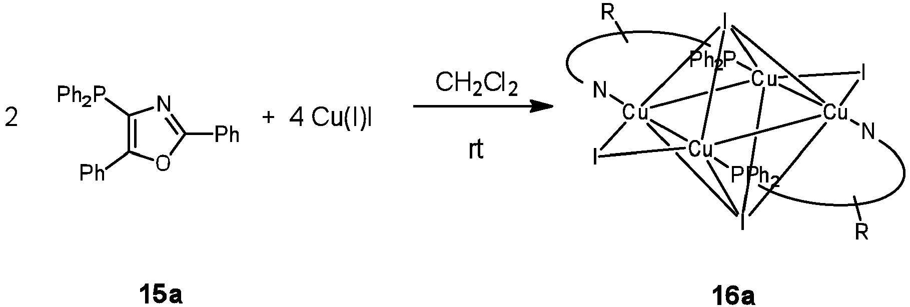

Bei der Verbindung **16a** handelt es sich um einen weißen, feinkristallinen Feststoff.

Charakterisierung:
Elementaranalyse:

| | |
|---|---|
| **16a** | ber.: C 39.85; H 2.55; N 1.69 (x1 CH₂Cl₂) |
| | gef.: C 40.04; H 2.43; N 1.40 |

### IX. P∩N* = Ph₂PThiazol, 17a: Cu₄I₄(Ph₂PThiazol)₂, 18a

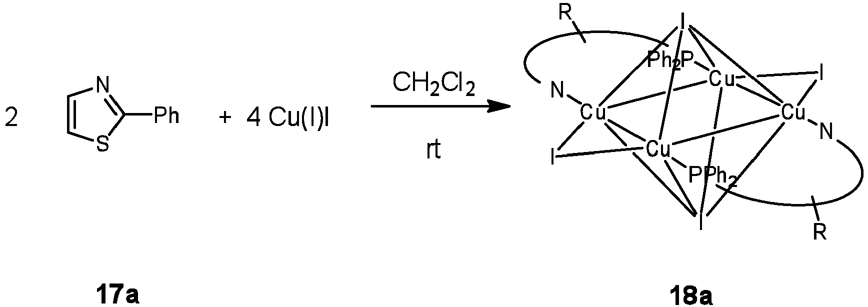

Bei der Verbindung **18a** handelt es sich um einen weißen, feinkristallinen Feststoff.

Charakterisierung:
Elementaranalyse:

| | |
|---|---|
| **18a** | ber.: C 27.28; H 1.88; N 2.09; S 4.78 (x1/2 CH₂Cl₂) |
| | gef.: C 26.80; H 1.96; N 1.73; S 4.60 |

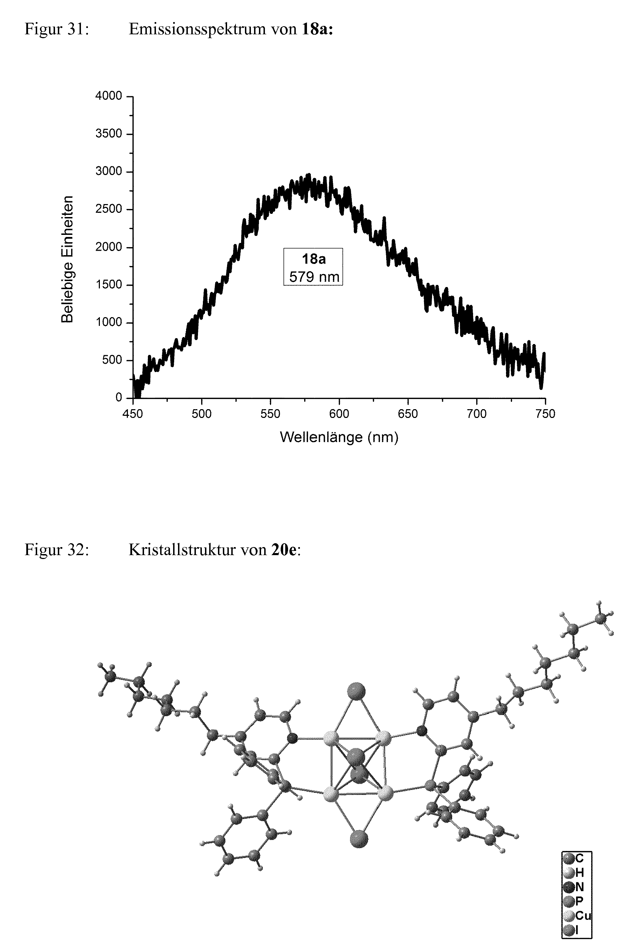

Das Emissionsspektrum von **18a** ist in Fig. 31 dargestellt

### X. P∩N* = Ph₂PPyridin, 19a-g: Cu₄I₄(Ph₂PPyridin)₂, 20a-g

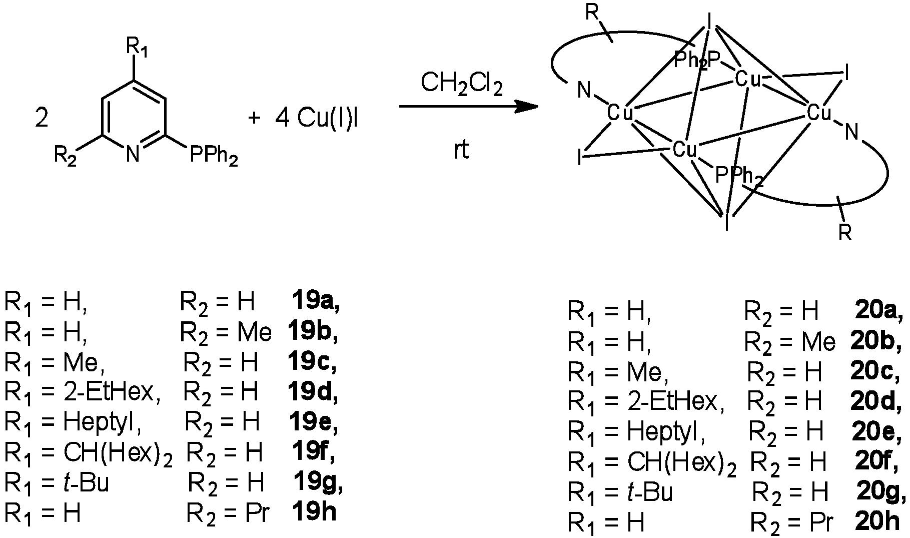

Bei den Verbindungen **20a-h** handelt es sich um gelbliche, feinkristalline Feststoffe.

Charakterisierung:
Elementaranalyse:

| | |
|---|---|
| **20a** (R₁ = H; R₂ = H) | ber.: C 31.14; H 2.20; N 2.10 (x1/2 CH₂Cl₂) |
| | gef.: C 31.14; H 2.21; N 1.97 |
| **20b** (R₁ = H; R₂ = Me) | ber.: C 32.85; H 2.45; N 2.13 |
| | gef.: C 32.49; H 2.38; N 1.88 |
| **20c** (R₁ = Me; R₂ = H) | ber.: C 32.85; H 2.45; N 2.13 |
| | gef.: C 32.73; H 2.38; N 1.87 |
| **20d** (R₁ = 2-EtHex; R₂ = H) | ber.: C 40.53; H 4.19; N 1.82 |
| | gef.: C 40.38; H 4.18; N 1.55 |
| **20e** (R₁ = Heptyl; R₂ = H) | ber.: C 38.83; H 3.80; N 1.89 |
| | gef.: C 38.80; H 3.85; N 1.58 |
| **20f** (R₁ = *t*-Bu; R₂ = H) | ber.: C 34.77; H 3.12; N 1.89 (x1 CH₂Cl₂) |
| | gef.: C 34.62; H 3.12; N 1.89 |
| **20g** (R₁ = H; R₂ = Pr) | ber.: C 36.48; H 3.35; N 1.98 (x1/2 *n*-Hexan) |
| | gef.: C 36.55; H 3.10; N 1.83 |

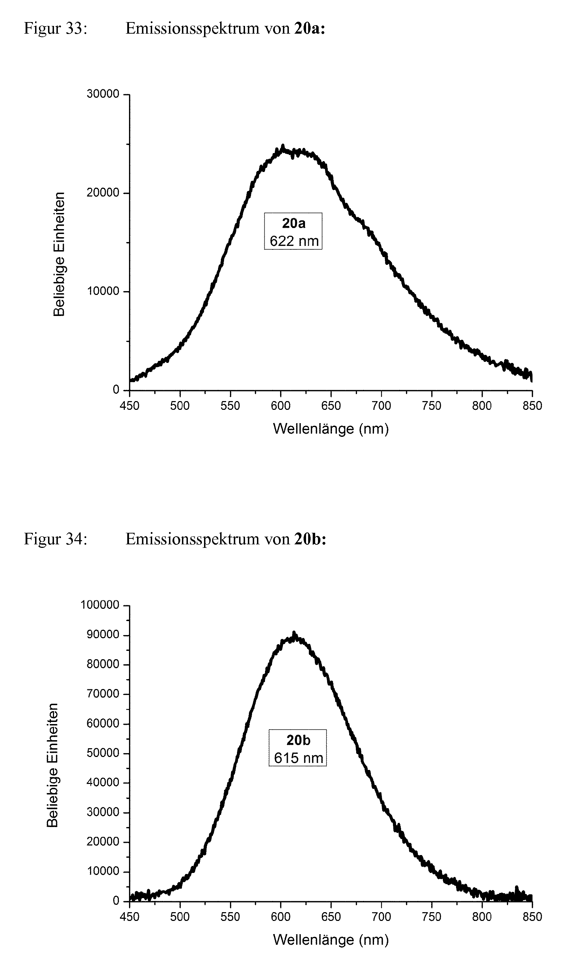

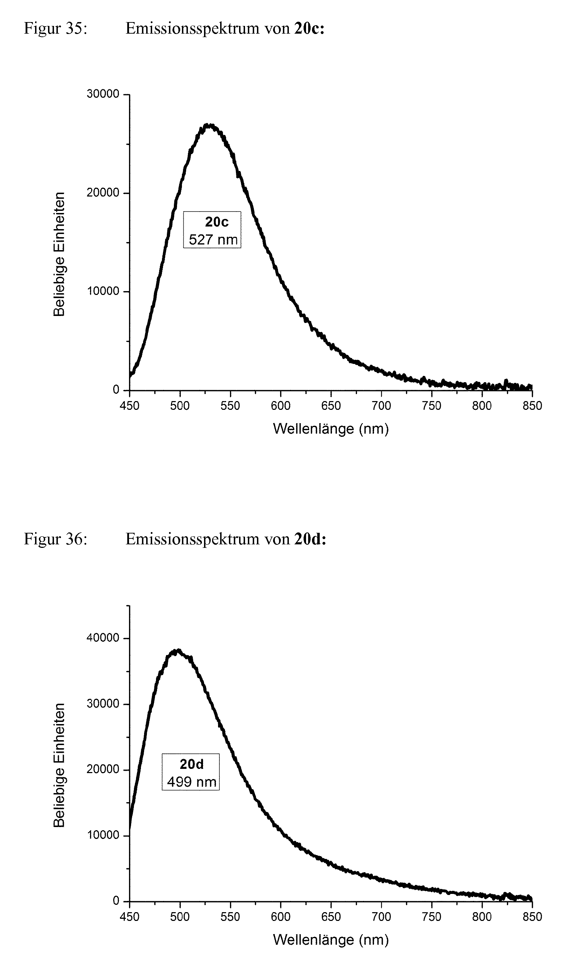

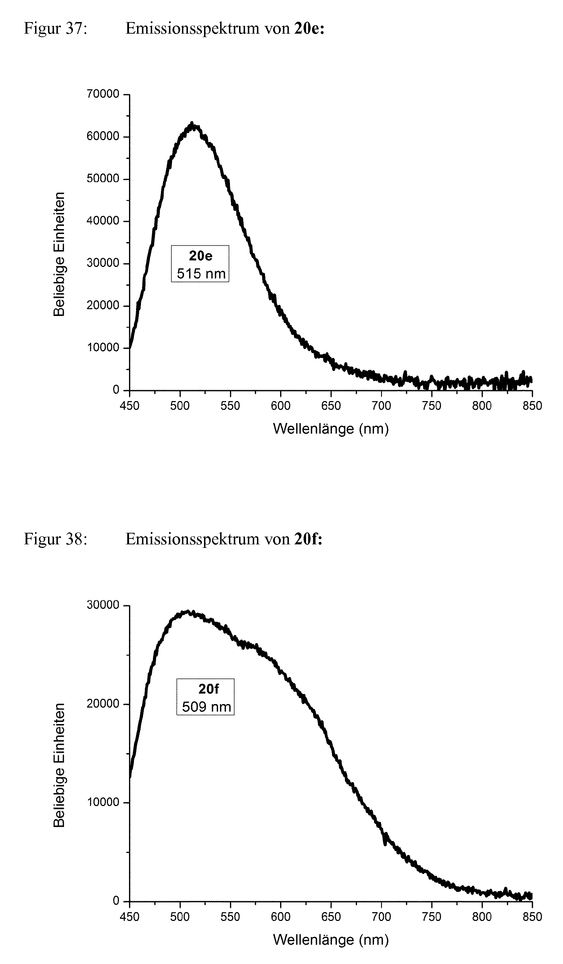

Die Kristallstruktur von **20e** ist in Fig. 32 dargestellt.
Die Emissionsspektren von **20a-g** sind in Fig. 33-39 gezeigt

### XI. P∩N* = Ph₂PPyrimidin, 21a: Cu₄I₄(Ph₂PPyrimidin)₂, 22a

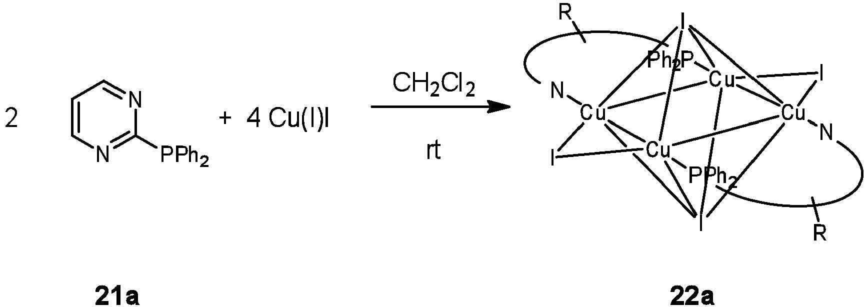

Bei der Verbindung **22a** handelt es sich um einen gelblichen, feinkristallinen Feststoff.

Charakterisierung:
Elementaranalyse:

| | |
|---|---|
| **22a** | ber.: C 29.79; H 2.03; N 4.34 |
| | gef.: C 29.81; H 1.95; N 4.26 |

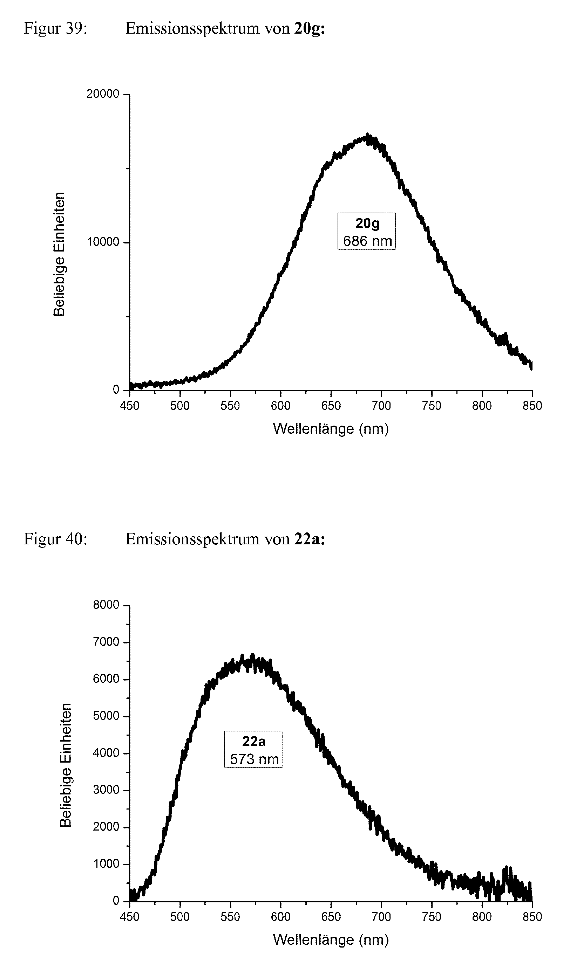

Die Emissionsspektren von **22a** sind in Fig. 40 gezeigt

## Patentansprüche

1. Kupfer(I)komplex der Formel A 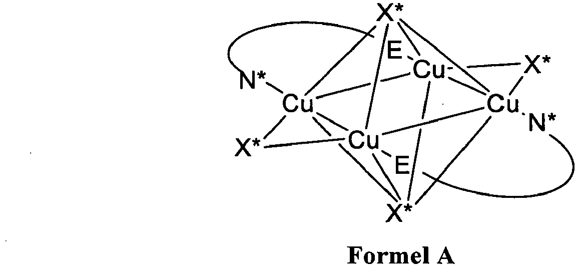 mit
X* = Cl, Br, I, CN und/oder SCN (also unabhängig voneinander)
N*∩E = ein zweibindiger Ligand mit
E = Phosphanyl/Arsenyl-Rest der Form R₂E (mit R = Alkyl, Aryl, Alkoxyl, Phenoxyl, oder Amid);
N* = Imin-Funktion, die Bestandteil eines N-heteroaromatischen 5-Rings ist, die ausgewählt ist aus der Gruppe bestehend aus Oxazol, Imidazol, Thiazol, Isoxazol, Isothiazol, Pyrazol, 1,2,3-Triazol, 1,2,3-Oxadiazol, 1,2,5-Oxadiazol, 1,2,3-Thiadiazol und 1,2,5-Thiadiazol, oder Imin-Funktion, die Bestandteil eines N-heteroaromatischen 6-Rings ist, die ausgewählt ist aus der Gruppe bestehend aus Pyridin, Pyrimidin, Triazin, Pyrazin und Pyridazin;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet;
wobei N*∩E optional mindestens einen Substituenten zur Erhöhung der Löslichkeit des Kupfer(I)komplexes in einem organischen Lösungsmittel aufweist.

2. Kupfer(I)komplex nach Anspruch 1, wobei N*∩E ausgewählt ist aus der Gruppe bestehend aus
| | |
|---|---|
| 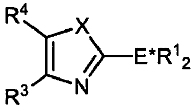 | X = NR²: 1R²-2E*R¹₂-4R³-5R⁴-1*H*-Imidazol |
| | X = O: 2E*R¹₂-4R³-5R⁴-Oxazol |
| | X = S: 2E*R¹₂-4R³-5R⁴-Thiazol |
| 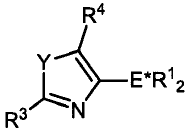 | Y = NR²: 1R²-4E*R¹₂-2R³-5R⁴-1*H*-Imidazol |
| | Y = O: 4E*R¹₂-2R³-5R⁴-Oxazol |
| | Y = S: 4E*R¹₂-2R³-5R⁴-Thiazol |
| | |
| 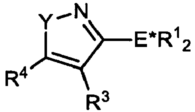 | Y = NR²: 1R²-3E*R¹₂-4R³-5R⁴-1*H*-Pyrazol |
| | Y = O: 3E*R¹₂-4R³-5R⁴-Isoxazol |
| | Y = S: 3E*R¹₂-4R³-5R⁴-Isothiazol |
| | |
| 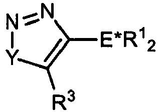 | Y = NR²: 1R²-4E*R¹₂-5R³-1*H*-1,2,3-Triazol |
| | Y = O: 4E*R¹₂-5R³-1,2,3-Oxadiazol |
| | Y = S: 4E*R¹₂-5R³-1,2,3-Thiadiazol |
| | |
| 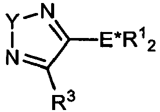 | Y = NR²: 2R²-4E*R¹₂-5R³-2*H*-1,2,3-Triazol |
| | Y = O: 3E*R¹₂-4R³-1,2,5-Oxadiazol |
| | Y = S: 3E*R¹₂-4R³-1,2,5-Thiadiazol |
| 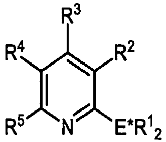 | 2E*R¹₂-3R²-4R³-5R⁴-6R⁵-Pyridin |
| 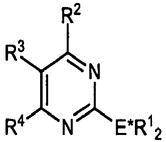 | 2E*R¹₂-4R²-5R³-6R⁴-Pyrimidin |
| 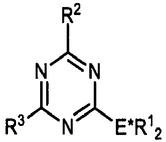 | 2E*R¹₂-4R²-6R³-1,3,5-Triazin |
| 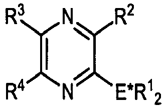 | 2E*R¹₂-3R²-5R³-6R⁴-Pyrazin |
| 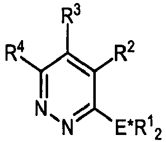 | 3E*R¹₂-4R²-5R³-6R⁴-Pyridazin |
| 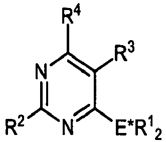 | 4E*R¹₂-2R²-5R³-6R⁴-Pyrimidin |
mit
X = O oder NR²
Y = O oder NR² oder S
E* = As oder P
R1-R5 können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen. R2-R5 können optional auch zu annelierten Ringsystemen führen.

3. Kupfer(I)komplex nach Anspruch 1 oder 2, wobei der Substituent zur Erhöhung der Löslichkeit ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

4. Verfahren zur Herstellung eines Kupfer(I)komplexes nach Anspruch 1 bis 3,
aufweisend den folgenden Schritt:
Durchführen einer Reaktion von N*∩E mit Cu(I)X*,
wobei
X* = Cl, Br, I, CN oder SCN (unabhängig voneinander)
N*∩E = ein zweibindiger Ligand mit
E = Phosphanyl/Arsenyl-Rest der Form R₂E (mit R = Alkyl, Aryl, Alkoxyl, Phenoxyl, oder Amid);
N* = Imin-Funktion, die Bestandteil eines N-heteroaromatischen 5-Rings ist die ausgewählt ist aus der Gruppe bestehend aus Oxazol, Imidazol, Isoxazol, Pyrazol, Triazol und Oxadiazol, oder
Imin-Funktion, die Bestandteil eines N-heteroaromatischen 6-Rings ist die ausgewählt ist aus der Gruppe bestehend aus Pyridin, Pyrimidin, Triazin, Pyrazin und Pyridazin;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet.

5. Verfahren nach Anspruch 4, wobei die Reaktion in Dichlormethan durchgeführt wird.

6. Verfahren nach Anspruch 4 oder 5, weiterhin aufweisend den Schritt der Zugabe von Diethylether oder Pentan zur Gewinnung des Kupfer(I)komplexes in Form eines Feststoffs.

7. Verfahren nach Anspruch 4 bis 6, weiterhin aufweisend den Schritt der Substitution mindestens eines Liganden N*∩E mit mindestens einem Substituenten, der ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

8. Verwendung eines Kupfer(I)komplexes nach Anspruch 1 bis 3 als Emitter oder Absorber in einem optoelektronischen Bauelement.

9. Verwendung nach Anspruch 8, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

10. Optoelektronisches Bauelement, aufweisend einen Kupfer(I)komplex nach Anspruch 1 bis 3.

11. Optoelektronisches Bauelement nach Anspruch 10, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

12. Verfahren zur Herstellung eines optoelektronischen Bauelements, wobei ein Kupfer(I)komplex nach Anspruch 1 bis 3 verwendet wird.

13. Verfahren nach Anspruch 12, **gekennzeichnet durch**
Aufbringen eines Kupfer(I)komplexes nach Anspruch 1 bis 3 auf einen Träger.

14. Verfahren nach Anspruch 13, **dadurch gekennzeichnet, dass** das Aufbringen nass-chemisch, mittels kolloidaler Suspension oder mittels Sublimation erfolgt.

15. Zweizähniger Ligand ausgewählt aus der Gruppe bestehend aus 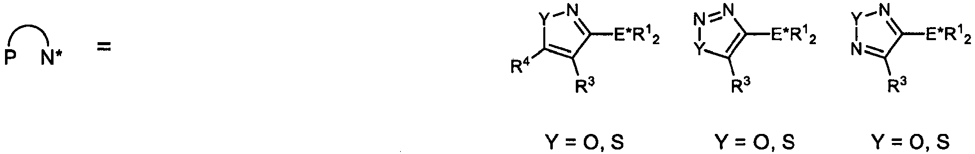 , insbesondere zur Herstellung eines Kupferkomplexes der Formel A,
wobei die verwendeten Symbole in den Ansprüchen 1 und 2 definiert sind.

16. Verfahren zur Herstellung eines Liganden nach Anspruch 15, gemäß folgender Reaktion a)
a) 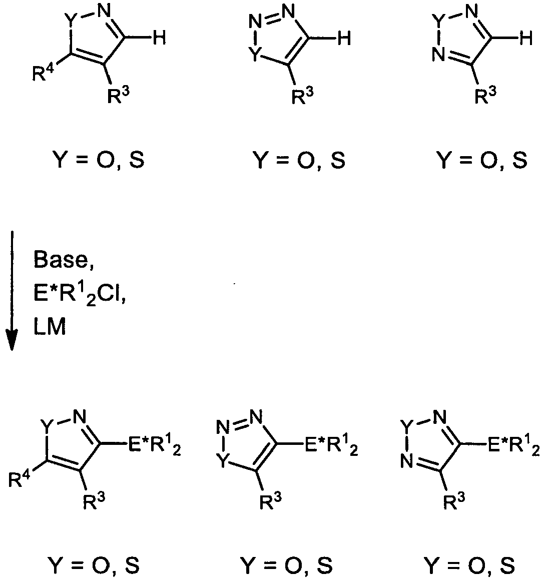 wobei die verwendeten Symbole in den Ansprüchen 1 und 2 definiert sind.

17. Verwendung eines Liganden der Formel B zur Herstellung eines Kupferkomplexes der Formel A, 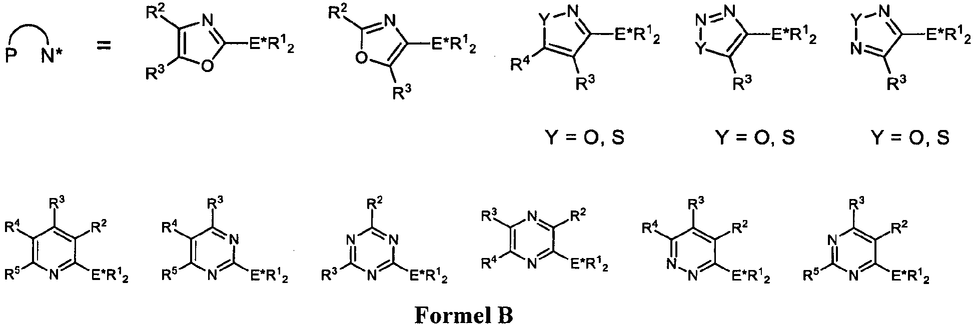 wobei die verwendeten Symbole in den Ansprüchen 1 und 2 definiert sind.

## Claims

1. Copper(I) complex of formula A 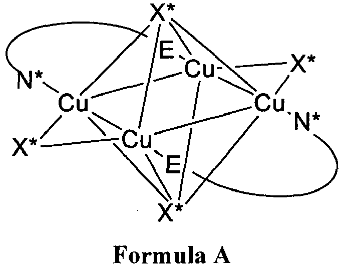 with
X* = Cl, Br, I, CN and/or SCN (independently of each other)
N*∩E = a bidentate ligand with
E = phosphanyl/arsenyl group of the R₂E form (with R = alkyl, aryl, alkoxyl, phenoxyl, or amide);
N* = imine function, which is part of a N-heteroaromatic 5-membered ring, which is chosen from the group consisting of oxazole, imidazole, thiazole, isoxazole, isothiazole, pyrazole, 1,2,3-triazole, 1,2,3-oxadiazole, 1,2,5-oxadiazole, 1,2,3-thiadiazole and 1,2,5-thiadiazole, or imine function, which is part of a N-heteroaromatic 6-membered ring, which is chosen from the group consisting of pyridine, pyrimidine, triazine, pyrazine and pyridazine;
"∩" = at least one carbon atom, which is likewise part of the aromatic group, wherein the carbon atom is directly adjacent to both the imine nitrogen atom and to the phosphorous or arsenic atom;
wherein N*∩E optionally has at least one substituent for increasing the solubility of the copper(I) complex in an organic solvent.

2. Copper(I) complex according to claim 1, wherein N*∩E is chosen from the group consisting of
| | |
|---|---|
| 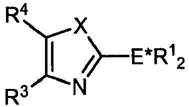 | X = NR²: 1R²-2E*R¹₂-4R³-5R⁴-1*H*-Imidazole |
| | X = O: 2E*R¹₂-4R³-5R⁴-Oxazole |
| | X = S: 2E*R¹₂-4R³-5R⁴-Thiazole |
| 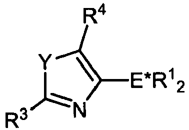 | Y = NR²: 1R²-4E*R¹₂-2R³-5R⁴-1*H*-Imidazole |
| | Y = O: 4E*R¹₂-2R³-5R⁴-Oxazole |
| | Y = S: 4E*R¹₂-2R³-5R⁴-Thiazole |
| | |
| 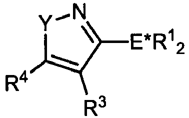 | Y = NR²: 1R²-3E*R¹₂-4R³-5R⁴-1*H*-Pyrazole |
| | Y = O: 3E*R¹₂-4R³-5R⁴-Isoxazole |
| | Y = S: 3E*R¹₂-4R³-5R⁴-Isothiazole |
| | |
| 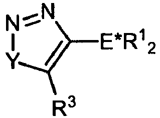 | Y = NR²: 1R²-4E*R¹₂-5R³-1*H*-1,2,3-Triazole |
| | Y = O: 4E*R¹₂-5R³-1,2,3-Oxadiazole |
| | Y = S: 4E*R¹₂-5R³-1,2,3-Thiadiazole |
| | |
| 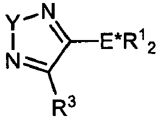 | Y = NR²: 2R²-4E*R¹₂-5R³-2*H*-1,2,3-Triazole |
| | Y = O: 3E*R¹₂-4R³-1,2,5-Oxadiazole |
| | Y = S: 3E*R¹₂-4R³-1,2,5-Thiadiazole |
| 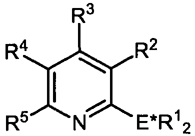 | 2E*R¹₂-3R²-4R³-5R⁴-6R⁵-Pyridine |
| 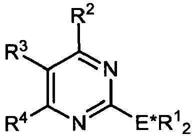 | 2E*R¹₂-4R²-5R³-6R⁴-Pyrimidine |
| 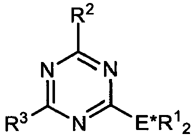 | 2E*R¹₂-4R²-6R³-1,3,5-Triazine |
| 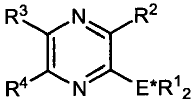 | 2E*R¹₂-3R²-5R³-6R⁴-Pyrazine |
| 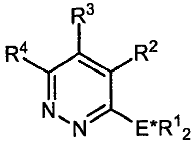 | 3E*R¹₂-4R²-5R³-6R⁴-Pyridazine |
| 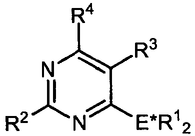 | 4E*R¹₂-2R²-5R³-6R⁴-Pyrimidine |
with
X = O or NR²
Y = O or NR² or S
E* = As or P
R1-R5 can be each independently from each other hydrogen, halogen or substituents which are bound via oxygen (-OR), nitrogen (-NR₂) or silicon atoms (-SiR₃) as well as alkyl- (also branched or cyclic), aryl-, heteroaryl-, alkenyl-, alkinyl-groups and respectively substituted alkyl- (also branched or cyclic), aryl-, heteroaryl- and alkenyl-groups with substituents such as halogens or deuterium, alkyl groups (also branched or cyclic), and further generally known donor and acceptor groups such as for example amines, carboxylates and their esters, and CF₃-groups; R2-R5 can optionally also lead to annulated ring systems.

3. Copper(I) complex according to claim 1 or 2, wherein the substituent for increasing solubility is chosen from the group consisting of:
- branched or unbranched or cyclic long-chained alkyl chains with a length of C1 to C30,
- branched or unbranched or cyclic long-chained alkoxy chains with a length of C1 to C30,
branched or unbranched or cyclic long-chained perfluoro alkyl chains with a length of C1 to C30, and
- short-chained polyethers with a chain length of 3-50 repeating units.

4. Method for preparing a copper(I) complex according to claim 1 to 3,
comprising the following step:
Performing a reaction of N*∩E with Cu(I)X*,
wherein
X* = Cl, Br, I, CN or SCN (independently from each other)
N*∩E = a bidentate ligand with
E = phosphanyl/arsenyl group of the R₂E form (with R = alkyl, aryl, alkoxyl, phenoxyl, or amide);
N* = imine function which is part of an N-heteroaromatic 5-membered ring chosen from the group consisting of oxazole, imidazole, isoxazole, pyrazole, triazole and oxadiazole, or
imine function which is part of an N-heteroaromatic 6-membered ring chosen from the group consisting of pyridine, pyrimidine, triazine, pyrazine and pyridazine;
"∩" = at least one carbon atom, which is likewise part of the aromatic group, wherein the carbon atom is directly adjacent both to the imine nitrogen atom and to the phosphorus or arsenic atom.

5. Method according to claim 4, wherein the reaction is performed in dichloromethane.

6. Method according to claim 4 or 5, furthermore comprising the step of the addition of diethyl ether or pentane in order to obtain the copper(I) complex in the form of a solid.

7. Method according to claim 4 to 6, furthermore comprising the step of the substitution of at least one ligand N*∩E with at least one substituent which can be chosen from the group consisting of:
- long-chained branched or unbranched or cyclic alkyl chains with a length of C1 to C30,
- long-chained branched or unbranched or cyclic alkoxy chains with a length of C1 to C30,
- branched or unbranched or cyclic perfluoro alkyl chains with a length of C1 to C30, and
- short-chained polyethers.

8. Use of a copper(I) complex according to claim 1 to 3 as emitter or absorber in an optoelectronic component.

9. Use according to claim 8, wherein the optoelectronic component is chosen from the group consisting of:
- organic light emitting components (OLEDs),
- light emitting electrochemical cells,
- OLED-sensors, in particular in gas and vapor sensors which are not hermetically screened from the outside,
- organic solar cells,
- organic field-effect transistors,
- organic lasers and
- down conversion elements.

10. Optoelectronic component comprising a copper(I) complex according to claims 1 to 3.

11. Optoelectronic component according to claim 10 shaped as a component chosen from the group consisting of organic light emitting component, organic diode, organic solar cell, organic transistor, organic light emitting diode, light emitting electrochemical cell, organic field-effect transistor and organic laser.

12. Method for the production of a optoelectronic component, wherein a copper(I) complex according to claim 1 to 3 is applied.

13. Method according to claim 12, **characterized by** application of a copper(I) complex according to claim 1 to 3 onto a carrier.

14. Method according to claim 13, **characterized in that** the application is carried out by wet-chemical means, by means of colloidal suspension or by means of sublimation.

15. Bidentate ligand chosen from the group consisting of 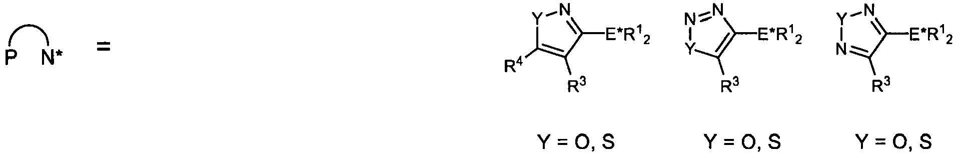 particularly for the preparation of a copper complex of formula A,
wherein the symbols used are defined in claims 1 and 2.

16. Method for the preparation of a ligand according to claim 15, pursuant to the following reaction a)
a) 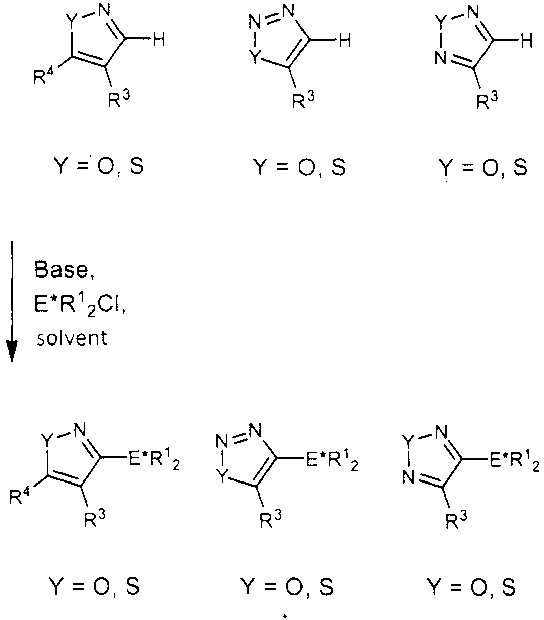 wherein the symbols used are defined in claims 1 and 2.

17. Use of a ligand of formula B for preparing a copper complex of formula A 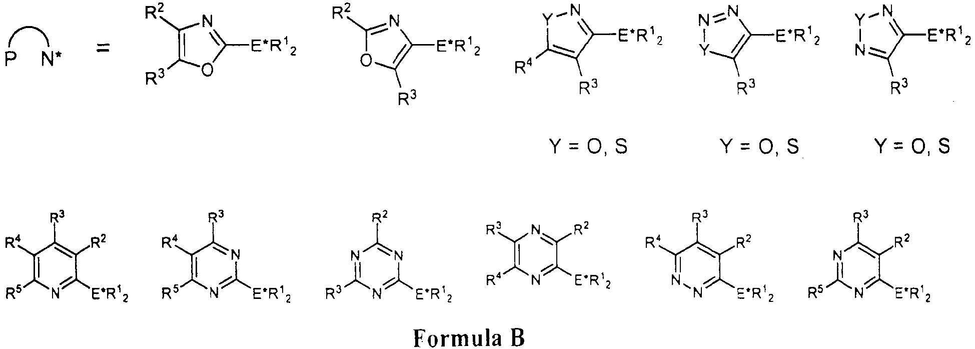 wherein the symbols used are defined in claims 1 and 2.

## Revendications

1. Complexe de cuivre(I) de formule A 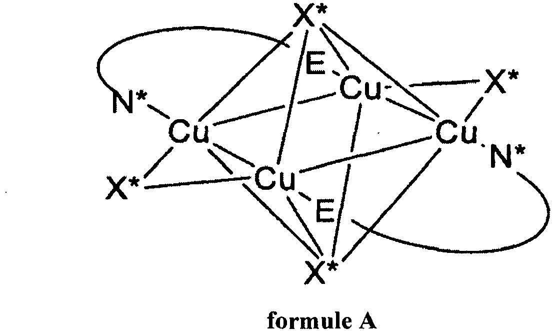 où
X* = Cl, Br, I, CN et/ou SCN (c'est-à-dire chaque fois indépendamment)
N*∩E = un ligand à deux liaisons où
E = un radical phosphanyle/arsényle de formule R₂E (où R = alkyle, aryle, alcoxy, phénoxy ou amido) ;
N* = une fonction imine qui fait partie d'un cycle pentagonal N-hétéroaromatique qui est choisie dans le groupe constitué par oxazole, imidazole, thiazole, isoxazole, isothiazole, pyrazole, 1,2,3-triazole, 1,2,3-oxadiazole, 1,2,5-oxadiazole, 1,2,3-thiazole et 1,2,5-thiadiazole, ou une fonction imine qui fait partie d'un cycle hexagonal N-hétéroaromatique qui est choisi dans le groupe constitué par pyridine, pyrimidine, triazine, pyrazine et pyridazine ;
« ∩ » = au moins un atome de carbone, qui fait également partie du groupe aromatique, l'atome de carbone se trouvant directement adjacent aussi bien à l'atome d'azote en fonction imine qu'à l'atome de phosphore ou d'arsenic,
N*∩E comportant en option au moins un substituant destiné à augmenter la solubilité du complexe de cuivre(I) dans un solvant organique.

2. Complexe de cuivre(I) selon la revendication 1, dans lequel N*∩E est choisi dans le groupe constitué par
| | |
|---|---|
| 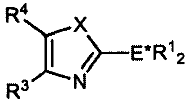 | X = NR²: 1R²-2E*R¹₂-4R³-5R⁴-1*H*-imidazole |
| | X = O: 2E*R¹₂-4R³-5R⁴-oxazole |
| | X = S: 2E*R¹₂-4R³-5R⁴-thiazole |
| | |
| 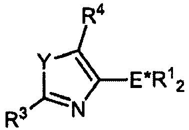 | Y = NR²: 1R²-4E*R¹₂-2R³-5R⁴-1*H*-imidazole |
| | Y = O: 4E*R¹₂-2R³-5R⁴-oxazole |
| | Y = S: 4E*R¹₂-2R³-5R⁴-thiazole |
| | |
| 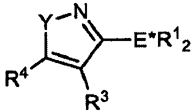 | Y = NR²: 1R²-3E*R¹₂-4R³-5R⁴-1*H*-pyrazole |
| | Y = O: 3E*R¹₂-4R³-5R⁴-isoxazole |
| | Y = S: 3E*R¹₂-4R³-5R⁴-isothiazole |
| | |
| 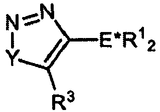 | Y = NR²: 1R²-4E*R¹₂-5R³-1*H*-1,2,3-triazole |
| | Y = O: 4E*R¹₂-5R³-1,2,3-oxadiazole |
| | Y = S: 4E*R¹₂-5R³-1,2,3-thiadiazole |
| | |
| 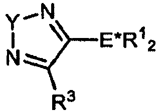 | Y = NR²: 2R²-4E*R¹₂-5R³-2*H*-1,2,3-triazole |
| | Y = O: 3E*R¹₂-4R³-1,2,5-oxadiazole |
| | Y = S: 3E*R¹₂-4R³-1,2,5-thiadiazole |
| 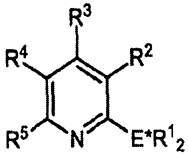 | 2E*R¹₂-3R²-4R³-5R⁴-6R⁵-pyridine |
| 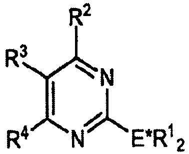 | 2E*R¹₂-4R²-5R³-6R⁴-pyrimidine |
| 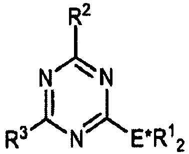 | 2E*R¹₂-4R²-6R³-1,3,5-triazine |
| 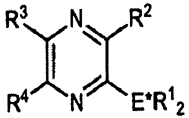 | 2E*R¹₂-3R²-5R³-6R⁴-pyrazine |
| 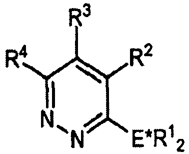 | 3E*R¹₂-4R²-5R³-6R⁴-pyridazine |
| 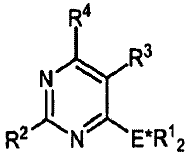 | 4E*R¹₂-2R²-5R³-6R⁴-pyrimidine |
où
X = O ou NR²
Y = O ou NR² ou S
E* = As ou P
R1-R5 peuvent être chacun indépendamment les uns des autres un atome d'hydrogène ou d'halogène ou des substituants qui sont liés par des atomes d'oxygène (-OR), d'azote (-NR₂) ou de silicium (-SiR₃), ainsi que des groupes alkyle (également ramifiés ou cycliques), aryle, hétéroaryle, alcényle, alcynyle ou des groupes alkyle (également ramifiés ou cycliques), aryle, hétéroaryle et alcényle substitués portant des substituants tels que des halogènes ou le deutérium, des groupes alkyle (également ramifiés ou cycliques) et d'autres groupes donneurs ou accepteurs généralement connus, comme par exemple des amines, des carboxylates et leurs esters, et des groupes CF₃; R2-R5 peuvent en option aussi conduire à des systèmes cycliques condensés.

3. Complexe de cuivre(I) selon la revendication 1 ou 2, dans lequel le substituant destiné à augmenter la solubilité est choisi dans le groupe constitué par :
- des chaînes alkyle à longue chaîne ramifiées ou non ramifiées ou cycliques ayant une longueur de C1 à C30,
- des chaînes alcoxy à longue chaîne ramifiées ou non ramifiées ou cycliques ayant une longueur de C1 à C30,
- des chaînes perfluoroalkyle à longue chaîne ramifiées ou non ramifiées ou cycliques ayant une longueur de C1 à C30, et
- des polyéthers à courte chaîne ayant une longueur de chaîne de 3-50 motifs répétitifs.

4. Procédé pour la préparation d'un complexe de cuivre(I) selon l'une quelconque des revendications 1 à 3, comportant l'étape suivante :
exécution d'une réaction de N*∩E avec Cu(I)X*,
où
X* = Cl, Br, I, CN ou SCN (chaque fois indépendamment)
N*∩E = un ligand à deux liaisons où
E = un radical phosphanyle/arsényle de forme R₂E (où R = alkyle, aryle, alcoxy, phénoxy ou amido) ;
N* = une fonction imine qui fait partie d'un cycle pentagonal N-hétéroaromatique qui est choisie dans le groupe constitué par oxazole, imidazole, isoxazole, pyrazole, triazole et oxadiazole, ou
une fonction imine qui fait partie d'un cycle hexagonal N-hétéroaromatique qui est choise dans le groupe constitué par pyridine, pyrimidine, triazine, pyrazine et pyridazine ;
« ∩ » = au moins un atome de carbone, qui fait également partie du groupe aromatique, l'atome de carbone se trouvant directement adjacent aussi bien à l'atome d'azote en fonction imine qu'à l'atome de phosphore ou d'arsenic.

5. Procédé selon la revendication 4, dans lequel la réaction est effectuée dans du dichlorométhane.

6. Procédé selon la revendication 4 ou 5, comportant en outre l'étape d'addition d'oxyde de diéthyle ou de pentane pour l'obtention du complexe de cuivre(I) sous forme d'un solide.

7. Procédé selon l'une quelconque des revendications 4 à 6, comportant en outre l'étape de substitution d'au moins un ligand N*∩E par au moins un substituant qui est choisi dans le groupe constitué par :
- des chaînes alkyle à longue chaîne ramifiées ou non ramifiées ou cycliques ayant une longueur de C1 à C30,
- des chaînes alcoxy à longue chaîne ramifiées ou non ramifiées ou cycliques ayant une longueur de C1 à C30,
- des chaînes perfluoroalkyle ramifiées ou non ramifiées ou cycliques ayant une longueur de C1 à C30, et
- des polyéthers à courte chaîne.

8. Utilisation d'un complexe de cuivre(I) selon l'une quelconque des revendications 1 à 3, en tant qu'émetteur ou absorbeur dans un composant optoélectronique.

9. Utilisation selon la revendication 8, dans laquelle le composant optoélectronique est choisi dans le groupe constitué par :
- des composants photoémetteurs organiques (OLED),
- des cellules électrochimiques photoémettrices,
- des capteurs OLED, en particulier dans des capteurs de gaz et de vapeur non hermétiquement isolés de l'extérieur,
- des cellules solaires organiques,
- des transistors à effet de champ organiques,
- des lasers organiques et
- des éléments de down-conversion.

10. Composant optoélectronique, comportant un complexe de cuivre(I) selon l'une quelconque des revendications 1 à 3.

11. Composant optoélectronique selon la revendication 10, conçu en tant qu'un composant choisi dans le groupe constitué par un composant photoémetteur organique, une diode organique, une cellule solaire organique, un transistor organique, une diode photoémettrice organique, une cellule électrochimique photoémettrice, un transistor à effet de champ organique et un laser organique.

12. Procédé pour la fabrication d'un composant optoélectronique, dans lequel on utilise un complexe de cuivre(I) selon l'une quelconque des revendications 1 à 3.

13. Procédé selon la revendication 12, **caractérisé par** l'application d'un complexe de cuivre(I) selon l'une quelconque des revendications 1 à 3 sur un support.

14. Procédé selon la revendication 13, **caractérisé en ce que** l'application s'effectue par voie chimique-humide, au moyen d'une suspension colloïdale ou par sublimation.

15. Ligand bidenté choisi dans le groupe constitué par 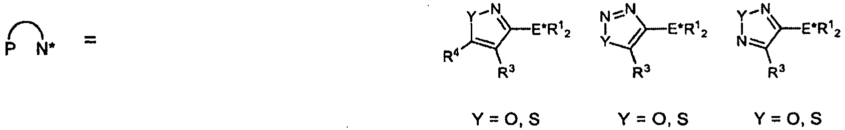 en particulier pour la préparation d'un complexe de cuivre de formule A,
les symboles utilisés étant définis dans les revendications 1 et 2.

16. Procédé pour la préparation d'un ligand selon la revendication 15, selon la réaction a) suivante
a) 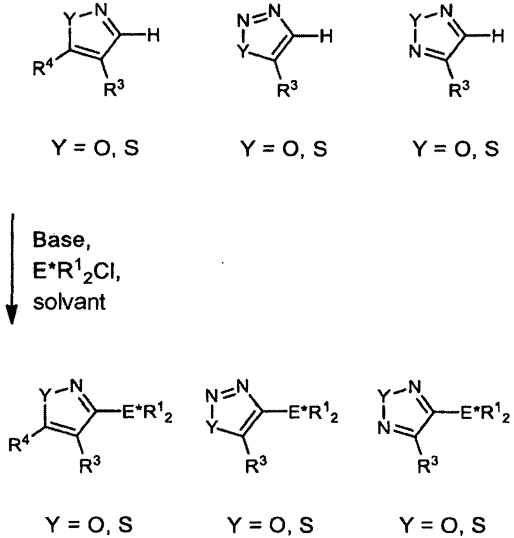 les symboles utilisés étant définis dans les revendications 1 et 2.

17. Utilisation d'un ligand de formule B pour la préparation d'un complexe de cuivre de formule A, 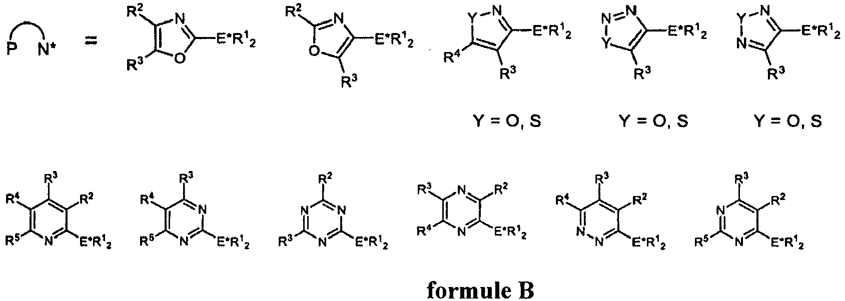 les symboles utilisés étant définis dans les revendications 1 et 2.
